# EUROPEAN PATENT SPECIFICATION

(11) **EP 3 557 324 B1**
(45) Date of publication and mention of the grant of the patent: **11.05.2022**
(21) Application number: 17896789.9
(22) Date of filing: 04.12.2017
(51) Int. Cl.: B41C 1/10, C08F 220/06, C08F 220/54, C08F 220/60, C08G 4/00, C08G 18/32, B41N 3/03

(54) **POSITIVE TYPE PLANOGRAPHIC PRINTING PLATE PRECURSOR AND METHOD OF PREPARING PLANOGRAPHIC PRINTING PLATE**
POSITIVE ARBEITENDER PLANOGRAFISCHER DRUCKPLATTENVORLÄUFER UND VERFAHREN ZUR HERSTELLUNG EINER PLANOGRAFISCHEN DRUCKPLATTE
PRÉCURSEUR DE PLAQUE D'IMPRESSION PLANOGRAPHIQUE POSITIVE ET PROCÉDÉ DE FABRICATION D'UNE PLAQUE D'IMPRESSION PLANOGRAPHIQUE

(30) Priority: 17.02.2017 JP 2017028334
(43) Date of publication of application: 23.10.2019
(73) Proprietor: FUJIFILM Corporation, Tokyo 106-8620 (JP)
(72) Inventor: YASUHARA, Yuichi, Haibara-gun Shizuoka 421-0396 (JP); NOZAKI, Atsuyasu, Haibara-gun Shizuoka 421-0396 (JP)
(74) Representative: Hoffmann Eitle
(86) International application number: PCT/JP2017/043489
(87) International publication number: WO 2018/150687

(56) References cited:
- WO-A1-2013/137345
- WO-A1-2014/106554
- WO-A1-2015/152209
- WO-A1-2016/047392
- JP-A- 2013 200 413
- JP-A- 2016 156 968

## Description

### BACKGROUND OF THE INVENTION

### 1. Field of the Invention

The present disclosure relates to a positive type planographic printing plate precursor and a method of preparing a planographic printing plate.

### 2. Description of the Related Art

In the related art, various photosensitive compositions have been used as materials for forming visible images or materials for planographic printing plates. Particularly, in recent years in the field of planographic printing, lasers have been remarkably developed, and in particular, solid-state lasers and semiconductor lasers having an emission region in a near infrared region to an infrared region, with a high output and a small size, have become easily available. In the field of planographic printing, as an exposure light source when manufacturing a printing plate directly from digital data from a computer or the like, these lasers are very useful.

A positive type planographic printing plate precursor for infrared laser has an alkali-soluble binder resin and an infrared absorbent (such as an infrared absorbing dye (IR dye)) which absorbs light and generates heat, as essential components. In the unexposed portion (image area), this IR dye and the like act as a development restrainer which substantially decreases the solubility of a binder resin in a developer due to an interaction with the binder resin, and in the exposed portion (non-image area), the interaction between the IR dye and the like and the binder resin weakens due to generated heat, the infrared absorbent and the like dissolve in an alkaline developer, and as a result, a planographic printing plate is formed.

As planographic printing plate precursors of the related art, those described in WO2015/152209A, EP1826001B, and WO2014/106554A have been known.

WO2015/152209 describes a photosensitive resin composition which contains a polymer compound containing a linking group represented by Formula A-1 and an infrared absorbing material.

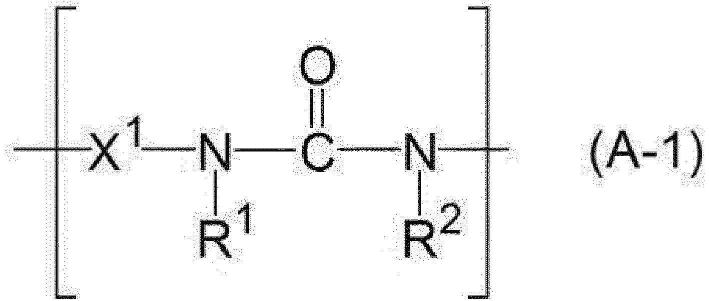

Various improved techniques have been suggested for the same purpose as described above. For example, EP1826001B describes a thermosensitive positive type planographic printing plate precursor which includes a support having a hydrophilic surface or a hydrophilic layer, and a thermosensitive layer containing an infrared absorbent, a phenol resin, and an alkali-soluble resin having a monomer unit represented by Formula I or II.

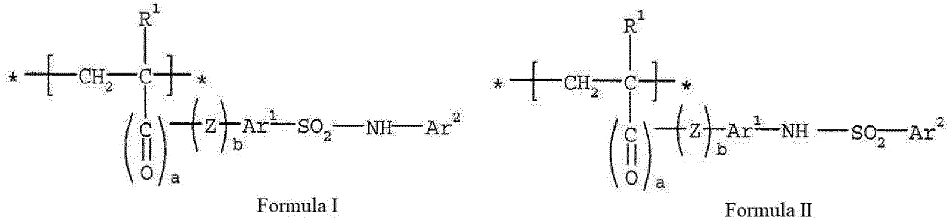

Further, WO2014/106554A describes a planographic printing plate precursor which contains a copolymer having a structure represented by Formula III and a structure represented by Formula IV and the above-described copolymer.

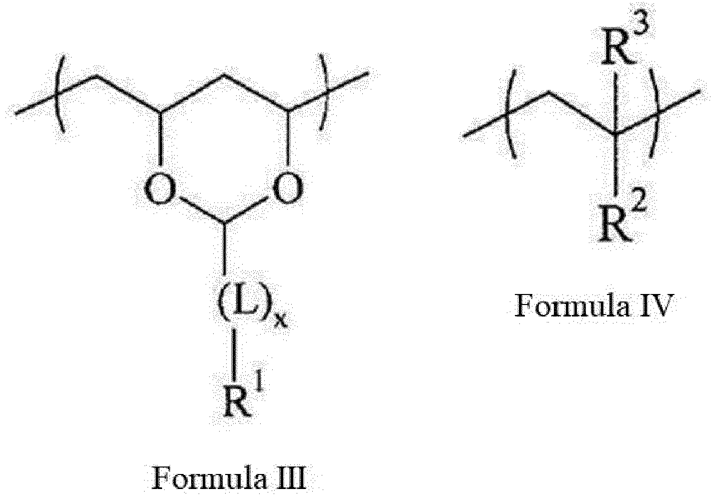

### SUMMARY OF THE INVENTION

In recent years, diversification of print materials (paper, ink, and the like) has progressed, and even in a case of using the same printing plate, there is a problem in that the number of printable sheets (hereinafter, referred to as "printing durability") is greatly reduced depending on the type of a print material.

WO2015/152209A describes a planographic printing plate precursor which has a urea bond in a main chain so that the precursor has excellent durability and chemical resistance.

In planographic printing plates described in EP1826001B and WO2014/106554A, high chemical resistance is obtained by using a polymer compound to which a unit with high chemical resistance has been introduced as one binder resin. However, since the strength of the image recording layer itself is weak, there is a problem in that the printing durability in printing is degraded in a case where a particularly low-quality print material (paper or ink) is used.

An object of an embodiment of the present invention is to provide a positive type planographic printing plate precursor from which a planographic printing plate with excellent printing durability is obtained, and a method of preparing a planographic printing plate.

Means for solving the above-described problems are defined in the claims.

According to the embodiment of the present invention, it is possible to provide a positive type planographic printing plate precursor from which a planographic printing plate with excellent printing durability is obtained, and a method of preparing a planographic printing plate.

### DESCRIPTION OF THE PREFERRED EMBODIMENTS

Hereinafter, the contents of the present disclosure will be described in detail. The description of constituent elements below is made based on representative embodiments of the present disclosure in some cases, but the present disclosure is not limited to such embodiments.

Further, in the present specification, the numerical ranges shown using "to" indicate ranges including the numerical values described before and after "to" as the lower limit values and the upper limit values.

In the present specification, in a case where substitution or unsubstitution is not noted in regard to the notation of a group (atomic group), the group includes not only a group that does not have a substituent but also a group having a substituent. For example, the concept of an "alkyl group" includes not only an alkyl group that does not have a substituent (unsubstituted alkyl group) but also an alkyl group having a substituent (substituted alkyl group).

In the present specification, the "polymer compound which has any one or both of a urea bond and a urethane bond in the main chain and contains an acid group" will be simply referred to as a "component A"

Further, in the present specification, "% by mass" has the same meaning as "% by weight" and "part(s) by mass" has the same meaning as "part(s) by weight".

The "steps" in the present specification include not only independent steps but also steps whose intended purposes are achieved even in a case where the steps cannot be precisely distinguished from other steps.

Further, in the present specification, a combination of preferred aspects is a more preferred aspect.

In the present specification, the molecular weight of a polymer component indicates the weight-average molecular weight (Mw) in terms of polystyrene which is measured by gel permeation chromatography (GPC) in a case of using tetrahydrofuran (THF) as a solvent.

### (Positive type planographic printing plate precursor)

A positive type planographic printing plate precursor according to the embodiment of the present disclosure (hereinafter, also simply referred to as a "planographic printing plate precursor") includes a support; and an image recording layer which contains a polymer compound 1 having a linking group represented by Formula A-1, a polymer compound 2-1 having at least one of a constitutional unit represented by Formula S-1 or a constitutional unit represented by Formula S-2 or a polymer compound 2-2 having a constitutional unit represented by Formula EV-1 and a constitutional unit represented by Formula EV-2, and an infrared absorbent, on the support.

As described above, the planographic printing plates described in EP1826001B and WO2014/106554A have a problem of deterioration of the printing durability.

As the result of intensive research conducted by the present inventors, it was found that a planographic printing plate with excellent printing durability is obtained according to the planographic printing plate precursor according to the embodiment of the present disclosure.

The detailed mechanism for obtaining the above-described effects is not clear, but it is considered that a sulfonamide group contained in a side chain of the polymer compound 2-1 or a phenolic hydroxyl group contained in a side chain of the polymer compound 2-2 has less steric hindrance so that the sulfonamide group or the phenolic hydroxyl group effectively interacts with a phenolic hydroxyl group contained in the main chain of the polymer compound 1. Accordingly, it is speculated that the strength of a planographic printing plate to be obtained is improved and the printing durability is improved because the interaction between the polymer compound 2-1 or the polymer compound 2-2 and the polymer compound 1 is strengthened.

In the present disclosure, the expression of "a polymer compound contains a phenolic hydroxyl group in the main chain" indicates that the polymer compound has an aromatic ring containing a phenolic hydroxyl group in the main chain.

Further, the present inventors found that a planographic printing plate with excellent printing durability is obtained in a case of using the positive planographic printing plate precursor according to the embodiment of the present disclosure.

The detailed mechanism for obtaining the above-described effects is not clear, but it is speculated that since the interaction between the polymer compound 2-1 or the polymer compound 2-2 and the polymer compound 1 is strengthened as described above, the chemical resistance is also improved.

In addition, the present inventors found that occurrence of development scum at the time of development of a positive type planographic printing plate precursor is suppressed in a case where the positive type planographic printing plate precursor according to the embodiment of the present disclosure is used.

As described above, since the polymer compound 2-1 or the polymer compound 2-2 and the polymer compound 1 interact with each other, these polymer compounds are considered to form aggregates even in a state of being dispersed in a developer.

Here, it is considered that since the polymer compound 2-1 and the polymer compound 2-2 each have a hydrophobic skeleton such as an acrylic chain or a butyral group in the main chain thereof, the aggregates tend to be extremely finely dispersed in a developer so that occurrence of development scum is suppressed.

Hereinafter, the details of each component contained in the planographic printing plate precursor according to the embodiment of the present disclosure will be described.

### <Polymer compound 1>

In the planographic printing plate precursor according to the embodiment of the present disclosure, the image recording layer contains the polymer compound 1 containing a linking group (hereinafter, also referred to as a "linking group A-1") represented by Formula A-1 in the main chain.

In the present disclosure, the "main chain" indicates the relatively longest bonding chain in a molecule of a polymer compound constituting a resin, and a "side chain" indicates a carbon chain branched from the main chain.

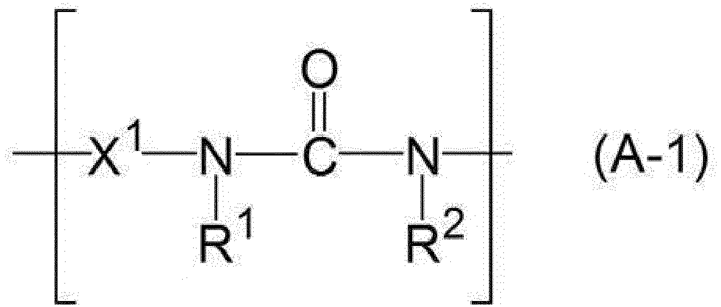

In Formula A-1, each of R¹ and R² independently represents a hydrogen atom or a monovalent organic group, preferably a hydrogen atom, an alkyl group, or an aryl group, more preferably a hydrogen atom, an alkyl group having 6 or less carbon atoms, or an aryl group having 6 to 10 carbon atoms, still more preferably a hydrogen atom or an alkyl group having 3 or less carbon atoms, and particularly preferably a hydrogen atom. In addition, it is particularly preferable that both of R¹ and R² represent a hydrogen atom.

X¹ represents a linking group represented by any of Formulae A-2 to A-6, preferably a linking group represented by Formula A-2, A-4, or A-5, and more preferably a linking group represented by Formula A-2.

In addition, the polymer compound 1 may have a plurality of linking groups represented by Formula A-1 which are different from one another as X¹, and it is preferable that at least one of these linking groups is a group containing a linking group represented by Formula A-2.

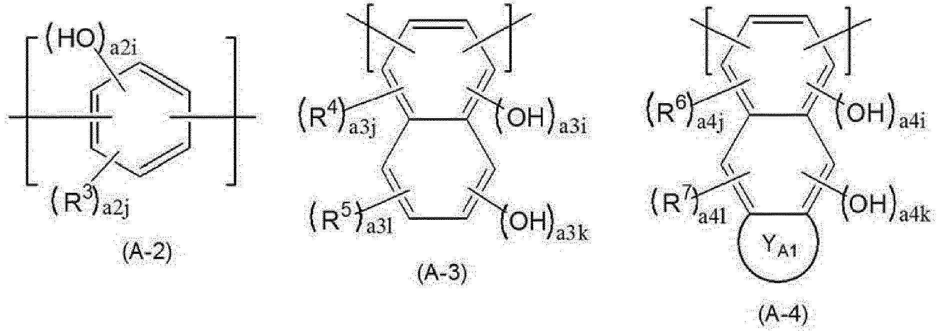

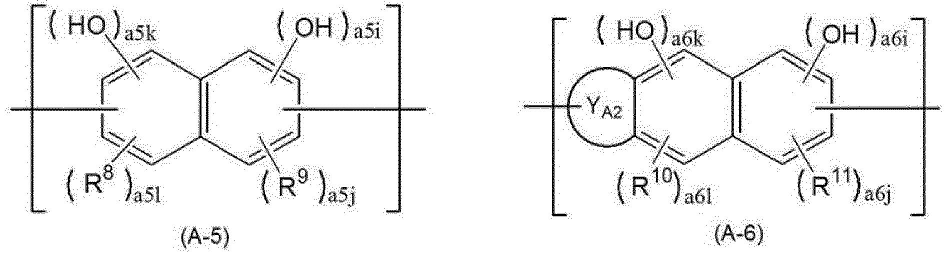

In Formulae A-2 to A-6, R³ represents a halogen atom or a monovalent organic group, a2i represents an integer of 1 to 4, a2j represents an integer of 0 to 3, a2i + a2j is 1 to 4, each of R⁴ and R⁵ independently represents a halogen atom or a monovalent organic group, each of a3i and a3j independently represents an integer of 0 to 2, each of a3k and a3l independently represents an integer of 0 to 4, a3i + a3k is 1 to 6, a3j + a3l is 0 to 6 - (a3i + a3k), each of R⁶ and R⁷ independently represents a halogen atom or a monovalent organic group, each of a4i and a4k independently represents an integer of 0 to 2, a4i + a4k is 1 to 4, each of a4j and a4l independently represents an integer of 0 to 2, a4j + a4l is 0 to 4 - (a4i + a4k), Y_{A1} represents an aromatic hydrocarbon ring or an aliphatic hydrocarbon ring, each of R⁸ and R⁹ independently represents a halogen atom or a monovalent organic group, each of a5i and a5k independently represents an integer of 0 to 3, a5i + a5k is 1 to 6, each of a5j and a51 independently represents an integer of 0 to 3, a5j + a5l is 0 to 6 - (a5i + a5k), each of R¹⁰ and R¹¹ independently represents a halogen atom or a monovalent organic group, a6k represents an integer of 0 to 2, a6i represents an integer of 0 to 3, a6i + a6k is 1 to 5, a6l represents an integer of 0 to 2, a6j represents an integer of 0 to 3, a6l + a6j is 0 to 5 - (a6i +a6k), and Y_{A2} represents an aromatic hydrocarbon ring or an aliphatic hydrocarbon ring.

R³ represents a halogen atom or a monovalent organic group, preferably a halogen atom, an alkyl group, or an aryl group, more preferably a halogen atom, an alkyl group having 6 or less carbon atoms, or an aryl group having 6 to 10 carbon atoms, and even still more preferably a halogen atom or an alkyl group having 3 or less carbon atoms.

a2i represents an integer of 1 to 4, preferably 1 or 2, and more preferably 1.

a2i + a2j is 1 to 4, a2j represents an integer of 0 to 3, preferably 0 or 1, and more preferably 0.

Further, two bonding site with respect to other structures are present in Formula A-2 that represents a divalent linking group, but it is preferable that one binding site is present at the para-position or meta-position while the other bonding site is present in a benzene ring described in Formula A-2.

It is preferable that the hydroxy group in Formula A-2 is bonded to the ortho-position of the bonding site with respect to two other structures.

Each of R₄ and R₅ independently represents a halogen atom or a monovalent organic group, preferably a halogen atom, an alkyl group, or an aryl group, more preferably a halogen atom, an alkyl group having 6 or less carbon atoms, or an aryl group having 6 to 10 carbon atoms, and still more preferably a halogen atom or an alkyl group having 3 or less carbon atoms.

Each of a3i and a3j independently represents an integer of 0 to 2, and each of a3k and a3l independently represents an integer of 0 to 4.

a3i + a3k is 1 to 6 and preferably 1 or 2. In a case where a3i + a3k is 2, it is preferable that a3i represents 1 and a3k represents 1.

a3j + a3l is 0 to 6 - (a3i + a3k) and preferably 0.

Further, two bonding sites with respect to other structures are present in Formula A-3 that represents a divalent linking group, but it is preferable that both bonding sites are bonded to the carbon atoms at the α-position of the naphthalene ring described in Formula A-3.

It is preferable that the hydroxy group in Formula A-3 is bonded to the carbon atom at the α-position of the naphthalene ring described in Formula A-3.

Each of R⁶ and R⁷ independently represents a halogen atom or a monovalent organic group, preferably a halogen atom, an alkyl group, or an aryl group, more preferably a halogen atom, an alkyl group having 6 or less carbon atoms, or an aryl group having 6 to 10 carbon atoms, and still more preferably a halogen atom or an alkyl group having 3 or less carbon atoms.

Each of a4i and a4k independently represents an integer of 0 to 2.

a4i + a4k is 1 to 4 and preferably 1 or 2. In a case where a4i + a4k is 2, a4i represents 0 and a4k represents 2.

Each of a4j and a4l independently represents an integer of 0 to 2, and a4j + a4l is 0 to 4 - (a4i + a4k) and preferably 0.

Y_{A1} represents an aromatic hydrocarbon ring or an aliphatic hydrocarbon ring, preferably an aromatic hydrocarbon ring, and more preferably a benzene ring.

In a case where Y_{A1} represents a benzene ring, in other words, Formula A-4 has an anthracene ring structure, it is preferable that the hydroxy group in Formula A-4 is bonded to the 9-position of the carbon atom and/or the carbon atom at the 10-position of the anthracene ring.

Further, two bonding sites with respect to other structures are present in Formula A-4 that represents a divalent linking group, but it is preferable that both bonding sites are respectively bonded to the carbon atom at the 1-position and the carbon atom at the 4-position.

Each of R⁸ and R⁹ independently represents a halogen atom or a monovalent organic group, preferably a halogen atom, an alkyl group, or an aryl group, more preferably a halogen atom, an alkyl group having 6 or less carbon atoms, or an aryl group having 6 to 10 carbon atoms, and still more preferably a halogen atom or an alkyl group having 3 or less carbon atoms.

Each of a5i and a5k independently represents an integer of 0 to 3.

a5i + a5k is 1 to 6 and preferably 1 or 2.

Each of a5j and a5l independently represents an integer of 0 to 3, and a5j + a5l is 0 to 6 - (a5i + a5k) and preferably 0.

Further, two bonding sites with respect to other structures are present in Formula A-5 that represents a divalent linking group, but it is preferable that both bonding sites are bonded to the carbon atom at the α-position of the naphthalene ring described in Formula A-5 and more preferable that both bonding sites are respectively bonded to the carbon atom at the 1-position and the carbon atom at the 5-position of the naphthalene ring.

It is preferable that the hydroxy group in Formula A-5 is bonded to the carbon atom at the α-position of the naphthalene ring described in Formula A-5.

Each of R¹⁰ and R¹¹ independently represents a halogen atom or a monovalent organic group, preferably an alkyl group or an aryl group, more preferably a halogen atom, an alkyl group having 6 or less carbon atoms, or an aryl group having 6 to 10 carbon atoms, and still more preferably a halogen atom or an alkyl group having 3 or less carbon atoms.

a6k represents an integer of 0 to 2, and a6i represents an integer of 0 to 3.

a6i + a6k is 1 to 5 and preferably 1 or 2.

A6l represents an integer of 0 to 2, and a6j represents an integer of 0 to 3.

a6l + a6j is 0 to 5 - (a6i +a6k) and preferably 0.

Y_{A2} represents an aromatic hydrocarbon ring or an aliphatic hydrocarbon ring, preferably an aromatic hydrocarbon ring, and more preferably a benzene ring.

In a case where Y_{A2} represents a benzene ring, in other words, Formula A-6 has an anthracene ring structure, it is preferable that the hydroxy group in Formula A-6 is bonded to the 9-position of the carbon atoms and/or the carbon atom at the 10-position of the anthracene ring.

Further, two bonding sites with respect to other structures are present in Formula A-6 that represents a divalent linking group, but it is preferable that both bonding sites are respectively bonded to the carbon atom at the 1-position and the carbon atom at the 8-position of the anthracene ring.

### [Linking group A-7]

It is preferable that the polymer compound 1 contains a linking group represented by Formula A-7 in the main chain.

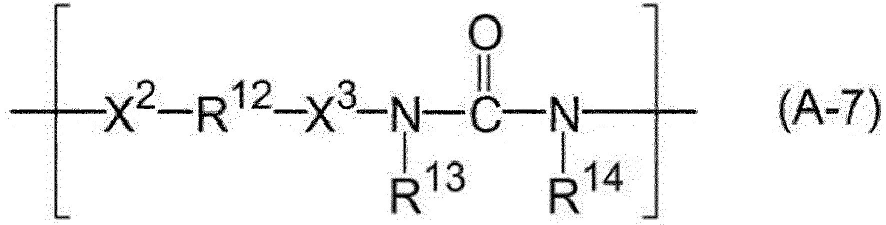

In Formula A-7, R¹² represents a single bond or a divalent linking group, each of R¹³ and R¹⁴ independently represents a hydrogen atom or a monovalent organic group, and each of X² and X³ independently represents a linking group represented by any of Formulae A-2 to A-6.

R¹² represents a single bond or a divalent linking group, preferably a single bond, an alkylene group having 6 or less carbon atoms, or a sulfonyl group, more preferably a single bond or an alkylene group having 5 or less carbon atoms, still more preferably a single bond or a methylene group, and particularly preferably a single bond. The alkylene group as R¹² may be linear, branched, or cyclic. Further, the alkylene group as R¹² may be substituted, and preferred examples of the substituent include an alkyl group having 4 or less carbon atoms, an aryl group, and a halogen atom. Further, the aryl group may be further substituted, and preferred examples of the substituent include a hydroxy group.

Each of R¹³ and R¹⁴ independently represents a hydrogen atom or a monovalent organic group, preferably an alkyl group or an aryl group, more preferably an alkyl group having 6 or less carbon atoms, or an aryl group having 6 to 10 carbon atoms, and still more preferably an alkyl group having 3 or less carbon atoms.

Each of X² and X³ independently represents a linking group represented by any of Formulae A-2 to A-6. In addition, it is preferable that at least one of X² or X³ represents a linking group represented by Formula A-2 and more preferable that both of X² and X³ represent a linking group represented by Formula A-2.

It is preferable that the linking group represented by Formula A-7 is a linking group represented by Formula A-8.

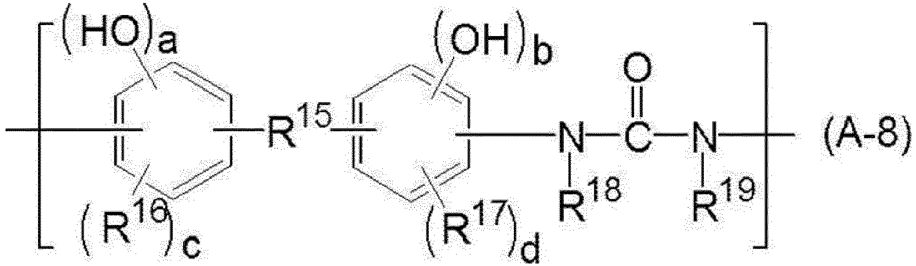

In Formula A-8, R¹⁵ represents a single bond or a divalent linking group, each of R¹⁶ and R¹⁷ independently represents a halogen atom or a monovalent organic group, each of R¹⁸ and R¹⁹ independently represents a hydrogen atom or a monovalent organic group, and each of a, b, c, and d independently represents an integer of 0 to 4, a + b represents 1 to 8, and c + d is 0 to 8 - (a + b).

R¹⁵ represents a single bond or a divalent linking group, preferably a single bond, an alkylene group having 6 or less carbon atoms, or a sulfonyl group, more preferably a single bond or an alkylene group having 5 or less carbon atoms, still more preferably a single bond or a methylene group, and particularly preferably a single bond. The alkylene group as R¹² may be linear, branched, or cyclic. Further, the alkylene group as R¹² may be substituted, and preferred examples of the substituent include an alkyl group having 4 or less carbon atoms, an aryl group, and a halogen atom. Further, the aryl group may be further substituted, and preferred examples of the substituent include a hydroxy group.

Each of R¹⁶ and R¹⁷ independently represents a halogen atom or a monovalent organic group, preferably a halogen atom, an alkyl group, or an aryl group, more preferably a halogen atom, an alkyl group having 6 or less carbon atoms, or an aryl group having 6 to 10 carbon atoms, still more preferably a halogen atom or an alkyl group having 3 or less carbon atoms, and particularly preferably a halogen atom.

Each of R¹⁸ and R¹⁹ independently represents a hydrogen atom or a monovalent organic group, preferably an alkyl group or an aryl group, more preferably an alkyl group having 6 or less carbon atoms, or an aryl group having 6 to 10 carbon atoms, and still more preferably an alkyl group having 3 or less carbon atoms.

Each of a, b, c, and d independently represents an integer of 0 to 4, a + b is 1 to 8, and c + d is 0 to 8 - (a + b).

It is preferable that each of a and b independently represents 1 or 2, more preferable that any one or both of a and b represent 1 or 2, and still more preferable that both of a and b represent 1.

It is preferable that each of c and d independently represents 0 or 1 and more preferable that both of c and d represent 0.

### [Linking group a-1]

Further, it is preferable that the linking group represented by Formula A-1 is a linking group represented by Formula a-1.

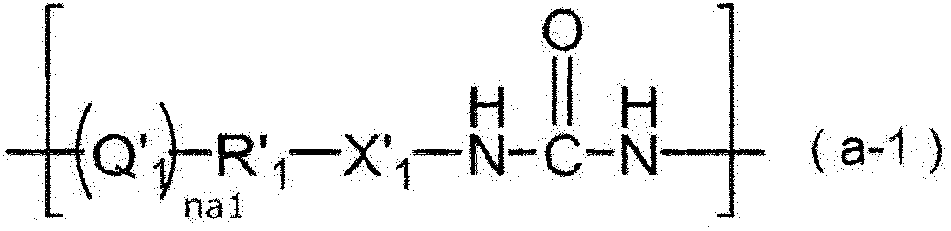

In Formula a-1, R'₁ represents a single bond or a divalent linking group, Q'₁ represents a divalent linking group, na1 represents an integer of 0 or greater, and X'₁ represents a divalent linking group and has the same definition as X¹ in Formula A-1, and the preferred examples thereof are the same as described above.

In Formula a-1, R'₁ represents a single bond or an alkylene group having 6 or less carbon atoms, more preferably a single bond or an alkylene group having 5 or less carbon atoms, still more preferably a single bond or a methylene group, and particularly preferably a single bond. The alkylene group as R'₁ may be linear, branched, or cyclic. Further, the alkylene group as R'₁ may be substituted, and preferred examples of the substituent include an alkyl group having 1 to 4 carbon atoms, an aryl group, and a halogen atom.

In a case where X'₁ represents a linking group represented by Formula A-2, Q'₁ represents a divalent linking group, preferably a divalent linking group having a urea bond, more preferably a divalent linking group having a urea bond and a phenylene group containing a hydroxy group, still more preferably a divalent linking group containing a linking group in which a urea bond and a phenylene group containing a hydroxy group are directly bonded to each other, and particularly preferably a divalent linking group in which a urea bond and a phenylene group containing a hydroxy group are directly bonded to each other. In addition, it is preferable that the phenylene group in all of the above-described linking groups is bonded to R'₁.

In a case where X'₁ represents a linking group represented by any of Formulae A-3 to A-6, Q'₁ represents a divalent linking group, preferably a divalent linking group having a urea bond, and more preferably a urea bond.

na1 represents an integer of 0 or greater, preferably 0 or 1, and more preferably 1.

### [Linking group a-2]

Further, it is preferable that the linking group a-1 is a linking group represented by Formula a-2.

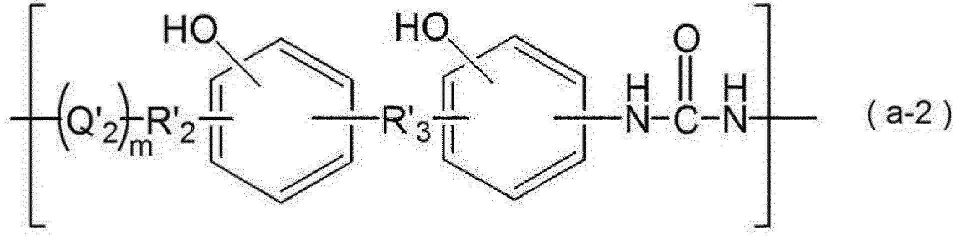

In Formula a-2, each of R'₂ and R'₃ independently represents a single bond or a divalent linking group, Q'₂ represents a divalent linking group, and m represents an integer of 0 or greater.

In Formula a-2, R'₂ represents a divalent linking group, preferably a divalent linking group having a urea bond, and more preferably a urea bond.

Q'₂ represents a single bond or a divalent linking group. It is more preferable that Q'₂ represents a single bond.

m represents an integer of 3 or less, more preferably an integer of 1 or less, and still more preferably 0.

In Formula a-2, R'₃ represents a single bond, an alkylene group having 6 or less carbon atoms, or a sulfonyl group, more preferably a single bond or an alkylene group having 5 or less carbon atoms, still more preferably a single bond or a methylene group, and particularly preferably a single bond. The alkylene group as R'₃ may be linear, branched, or cyclic. Further, the alkylene group as R'₃ may be substituted, and preferred examples of the substituent include an alkyl group having 4 or less carbon atoms, an aryl group, and a halogen atom. Further, the aryl group may be further substituted, and preferred examples of the substituent include a hydroxy group.

Further, in a case where R'₃ represents a single bond, it is preferable that the urea bond bonded to the benzene ring which is not bonded to R'₂ in Formula a-2 is bonded to the para-position of R'₃. Further, it is preferable that the hydroxy group in Formula a-2 is bonded to the ortho-position of the urea bond.

In a case where R'₂ represents a urea bond and R'₃ represents a single bond, both of two urea bonds bonded to the benzene ring in Formula a-2 are bonded to the para-position of R'₃. In this case, it is preferable that the hydroxy group in Formula a-2 is bonded to the ortho-position of a urea bond.

In a case where R'₃ represents an alkylene group, it is preferable that the urea bond bonded to the benzene ring which is not bonded to R'₂ in Formula a-2 is bonded to the para-position of R'₃. Further, it is preferable that the hydroxy group in Formula a-2 is bonded to the ortho-position of the urea bond.

In a case where R'₂ represents a urea bond and R'₃ represents an alkylene group, both of two urea bonds bonded to the benzene ring in Formula a-2 are bonded to the meta-position of R'₃. In this case, it is preferable that the hydroxy group in Formula a-2 is bonded to the ortho-position of a urea bond.

A planographic printing plate with excellent developability is obtained by the hydroxy group being bonded to the ortho-position of a urea bond on the benzene ring of Formula A-2.

### [Linking group a-2']

Further, it is preferable that the linking group a-1 is a linking group represented by Formula a-2'.

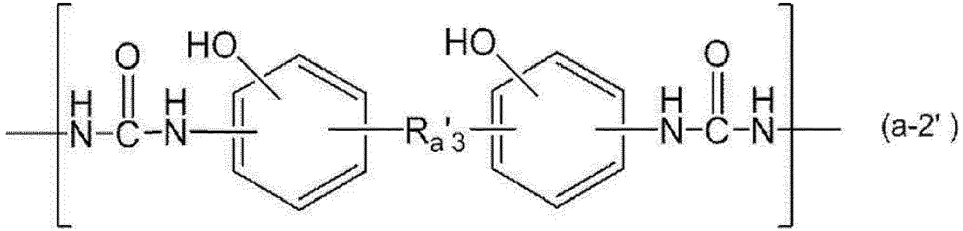

In Formula a-2', Rₐ'₃ represents a divalent linking group.

Since the description of Rₐ'₃ in Formula a-2' is the same as the description of R'₃ in Formula A-2, the description thereof will not be repeated.

Further, in a case where Rₐ'₃ represents a single bond, it is preferable that two urea bonds bonded to two benzene rings in Formula a-2' are bonded to the para-position of Rₐ'₃. In this case, it is preferable that the hydroxy group in Formula a-2' is bonded to the ortho-position of a urea bond.

In a case where Rₐ'₃ represents an alkylene group, it is preferable that two urea bonds bonded to two benzene rings in Formula a-2' are bonded to the meta-position of Rₐ'₃. In this case, it is preferable that the hydroxy group in Formula a-2' is bonded to the ortho-position of a urea bond.

A planographic printing plate with excellent developability is obtained by the hydroxy group being bonded to the ortho-position of a urea bond on the benzene ring of Formula a-2'.

Further, it is preferable that the linking group A-1 in the polymer compound 1 used in the present disclosure is a linking group obtained by reacting a diisocyanate compound with a diamine compound shown below.

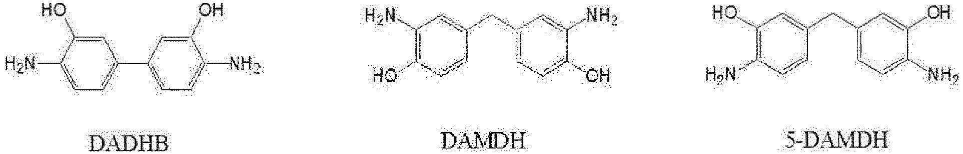

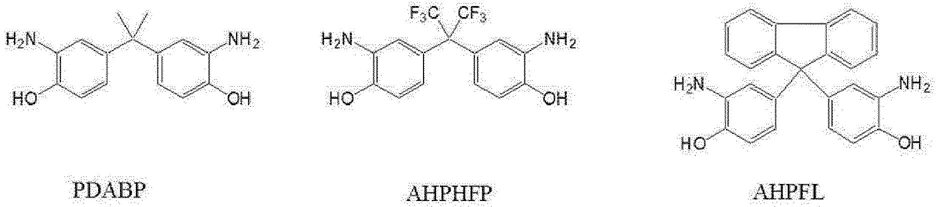

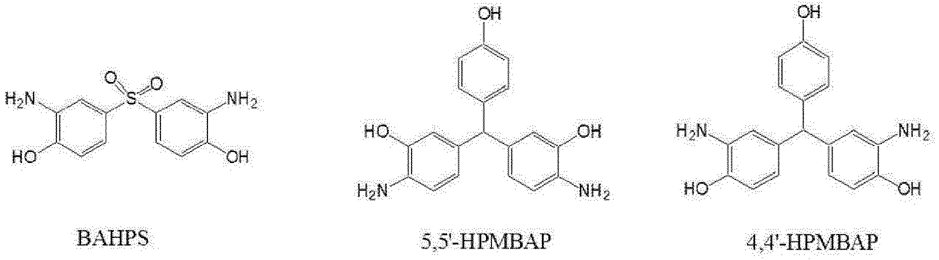

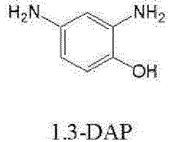

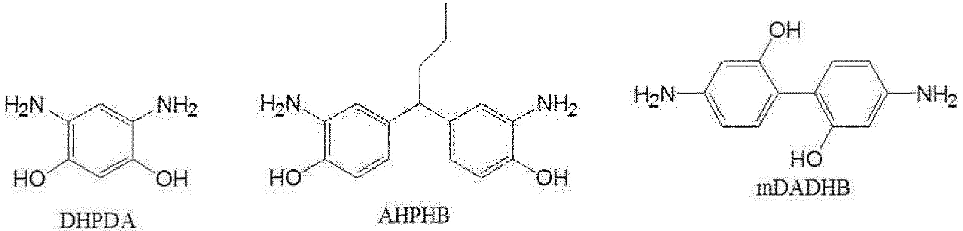

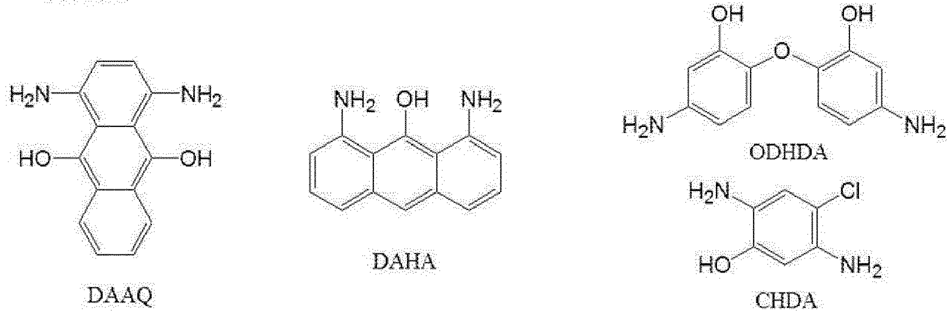

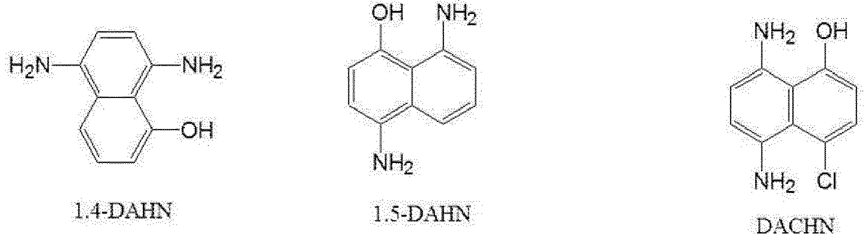

Among examples of the diamine compound, it is preferable to use DADHB, 1.3-DAP, DAMDH, PDABP, AHPHFP, or AHPFL and more preferable to use DADHB in order to obtain a linking group.

Further, it is preferable that the polymer compound 1 used in the present disclosure is a polyurea obtained by reacting at least the diamine compound with a diisocyanate compound.

Examples of the diisocyanate compound which is suitably used to synthesize the polymer compound 1 are shown below.

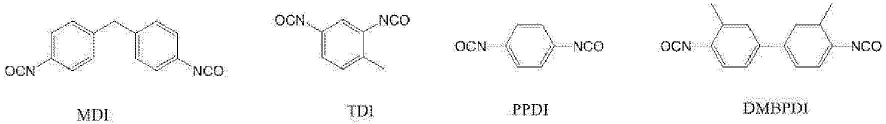

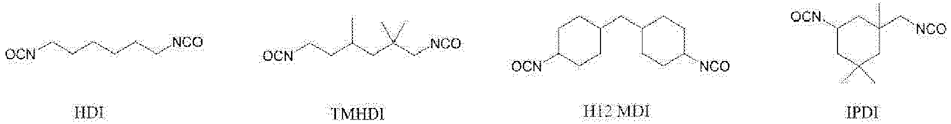

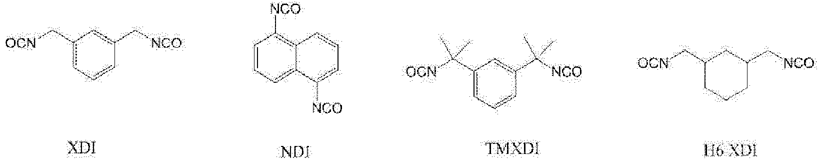

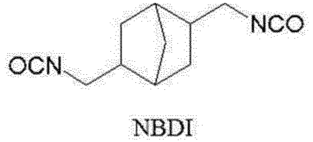

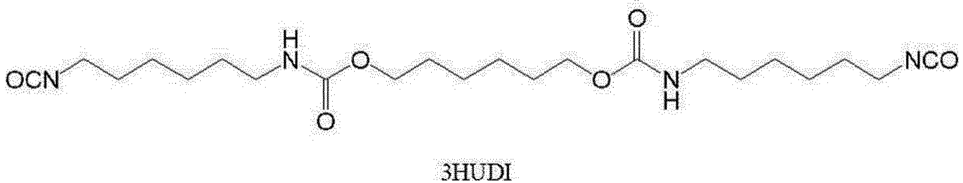

Examples of other diamine compounds which are suitably used to synthesize the polymer compound 1 are shown below.

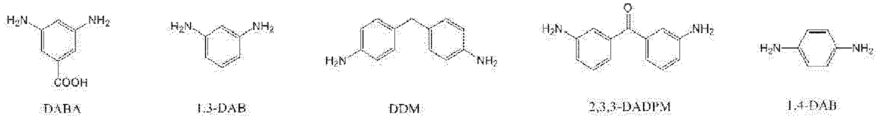

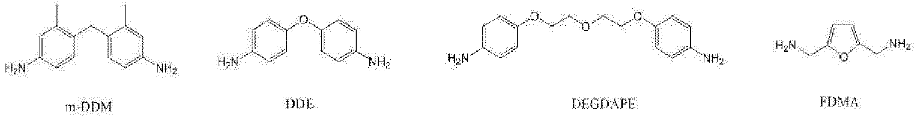

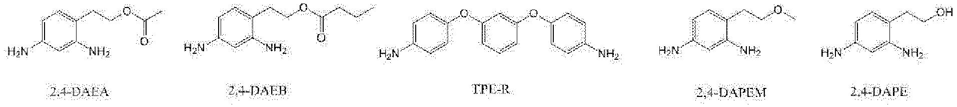

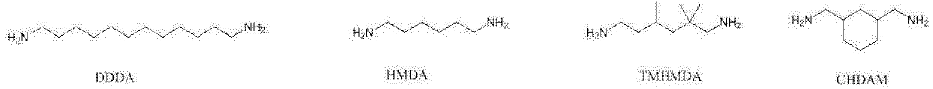

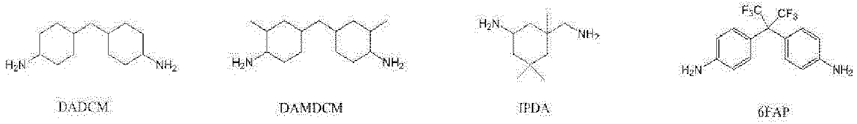

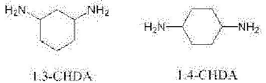

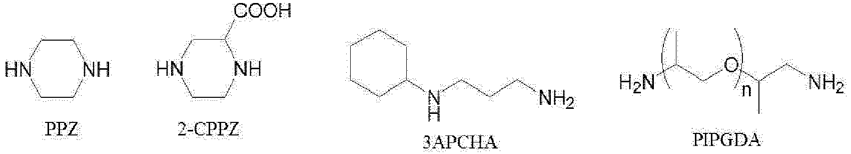

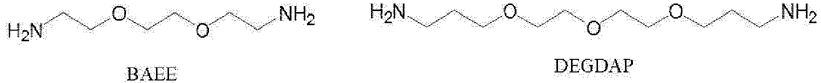

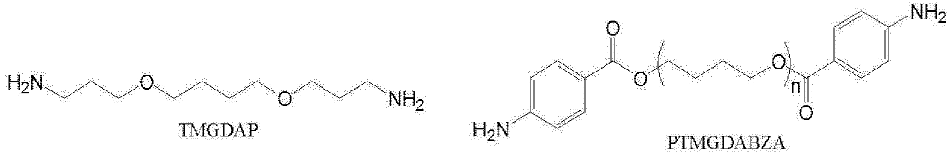

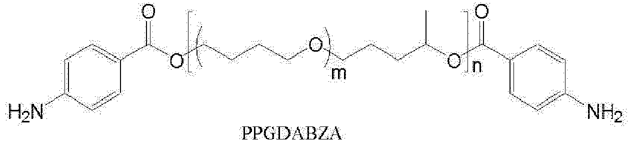

In the formulae shown above, each of m and n independently represents an integer of 1 to 100.

The polymer compound 1 is generated by sequentially polymerizing a compound containing two or more isocyanate groups and a compound containing two or more amino groups.

It is more preferable that the polymer compound 1 used in the present disclosure is generated by carrying out a sequential polymerization reaction of a diisocyanate compound and a diamine compound.

It is preferable that the diamine compound contains a moiety obtained by removing the urea bond of the linking group A-1.

As the diisocyanate compound, an aliphatic or aromatic hydrocarbon having 20 or less carbon atoms which contains two isocyanate groups is preferable, alkylene diisocyanate is more preferable, and hexamethylene diisocyanate is still more preferable.

Further, the reaction can be carried out by further adding a diamine compound.

Specific preferred examples of the polymer compound 1 are listed in Tables 1 and 2 shown below. Specific examples PU-1 to PU-35 indicate polymer compounds 1 formed by reacting the diamine compound with the diisocyanate compound listed in Tables 1 and 2 at ratios (molar ratios) listed in Tables 1 and 2.

In addition, the weight-average molecular weight (Mw) is a value measured by the GPC method.

The polymer compounds containing the linking group A-1 used in the present disclosure are not limited to the specific examples listed in Tables 1 and 2 shown below.

**[Table 1]**

| | Diisocyanate compound (molar ratio thereof contained) | | Diamine compound (molar ratio thereof contained) | | Mw (ten thousand) |
|---|---|---|---|---|---|
| PU-1 | HDI | - | DADHB | - | 5.6 |
| | 50 | - | 50 | - | |
| PU-2 | TMHDI | - | DADHB | - | 6.2 |
| | 50 | - | 50 | - | |
| PU-3 | H6 XDI | - | DADHB | - | 5.8 |
| | 50 | - | 50 | - | |
| PU-4 | XDI | - | DADHB | - | 5.2 |
| | 50 | - | 50 | - | |
| PU-5 | XDI | TMHDI | DADHB | - | 5.2 |
| | 25 | 25 | 50 | - | |
| PU-6 | XDI | HDI | DADHB | - | 5.1 |
| | 25 | 25 | 50 | - | |
| PU-7 | XDI | H6 XDI | DADHB | - | 5.3 |
| | 25 | 25 | 50 | - | |
| PU-8 | H6 XDI | TMHDI | DADHB | - | 6.1 |
| | 25 | 25 | 50 | - | |
| PU-9 | HDI | - | DADHB | AHPHFP | 6.2 |
| | 50 | - | 25 | 25 | |
| PU-10 | HDI | - | DADHB | AHPFL | 5.8 |
| | 50 | - | 45 | 5 | |
| PU-11 | HDI | MDI | 1,3DAP | - | 5.4 |
| | 25 | 25 | 50 | - | |
| PU-12 | HDI | XDI | 1,3DAP | - | 6.2 |
| | 25 | 25 | 50 | - | |
| PU-13 | HDI | - | PDABP | - | 5.2 |
| | 50 | - | 50 | - | |
| PU-14 | HDI | - | DAMDH | - | 5.4 |
| | 50 | - | 50 | - | |
| PU-15 | HDI | - | DADHB | DABA | 5.0 |
| | 50 | - | 40 | 10 | |

**[Table 2]**

| | Diisocyanate compound (molar ratio thereof contained) | | Diamine compound (molar ratio thereof contained) | | Mw (ten thousand) |
|---|---|---|---|---|---|
| PU-16 | HDI | - | 1,3DAP | 2,4-DAEA | 5.2 |
| | 50 | - | 40 | 10 | |
| PU-17 | HDI | - | DAAQ | | 5.3 |
| | 50 | - | 50 | | |
| PU-18 | HDI | - | DADHB | BAEE | 5.5 |
| | 50 | - | 45 | 5 | |
| PU-19 | HDI | - | DADHB | DEGDAP | 4.8 |
| | 50 | - | 45 | 5 | |
| PU-20 | HDI | - | DADHB | TMGDAP | 4.9 |
| | 50 | - | 45 | 5 | |
| PU-21 | HDI | 3HUDI | DADHB | | 5.1 |
| | 45 | 5 | 50 | | |
| PU-22 | HDI | - | DADHB | PIPGDA | 4.8 |
| | 50 | - | 45 | 5 | |
| PU-23 | HDI | - | 1,5-DAHN | | 4.5 |
| | 50 | - | 50 | | |
| PU-24 | HDI | - | DAHA | | 4.7 |
| | 50 | - | 50 | | |
| PU-25 | HDI | - | 1,4-DAHN | | 5 |
| | 50 | - | 50 | | |
| PU-26 | HDI | - | mDADHB | | 5.8 |
| | 50 | - | 50 | | |
| PU-27 | H6 XDI | - | ODHDA | | 5.2 |
| | 50 | - | 50 | | |
| PU-28 | H6 XDI | - | DADHB | CHDA | 5.4 |
| | 50 | - | 40 | 10 | |
| PU-29 | H6 XDI | - | DADHB | DACHN | 5.1 |
| | 50 | - | 40 | 10 | |
| PU-30 | TDI | - | AHPHFP | | 4.9 |
| | 50 | - | 50 | | |
| PU-31 | TDI | - | DADHB | AHPHFP | 5.3 |
| | 50 | - | 30 | 20 | |
| PU-32 | TDI | - | BAHPS | | 5.6 |
| | 50 | - | 50 | | |
| PU-33 | TDI | - | DADHB | BAHPS | 5.2 |
| | 50 | - | 30 | 20 | |
| PU-34 | TDI | - | DADHB | | 6.2 |
| | 50 | - | 50 | | |
| PU-35 | TDI | - | DADHB | TMGDAP | 5.5 |
| | 50 | - | 40 | 10 | |

Among the examples shown above, PU-1, PU-4, PU-5, or PU-7 is preferable as the polymer compound 1 containing the linking group A-1.

The structural formula of PU-1 in Table 1 is shown below as an example of the polymer compound 1 used in the present disclosure. Further, each numerical value on the lower right side of parentheses indicates the molar ratio.

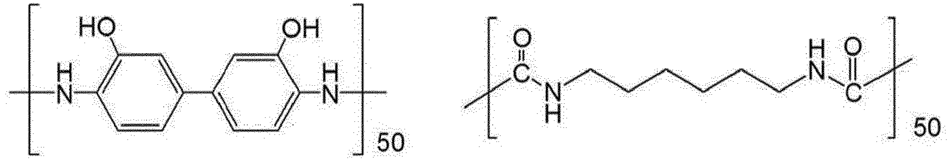

The content of the linking group A-1 in the polymer compound 1 containing the linking group A-1 is preferably in a range of 10% by mass to 80% by mass, more preferably in a range of 20% by mass to 70% by mass, and still more preferably in a range of 40% by mass to 70% by mass.

In a case where the content of the linking group A-1 is in the above-described range, a planographic printing plate with excellent chemical resistance can be obtained.

### [Other acid groups]

The polymer compound 1 contains a phenolic hydroxyl group in the main chain, and may further contain another acid group in any one or both of the main chain and a side chain.

The polymer compound 1 may contain another acid group in a side chain. As the acid group in a side chain, a phenolic hydroxyl group, a sulfonamide group, or a carboxy group is preferable.

Another acid group is introduced to the polymer compound 1, for example, in the form of being contained in another diamine compound described above.

Further, it is regarded that the polymer compound corresponding to the polymer compound 2-1 or the polymer compound 2-1, in other words, the polymer compound having at least one of a constitutional unit represented by Formula S-1 or a constitutional unit represented by Formula S-2 and the polymer compound having a constitutional unit represented by Formula EV-1 and a constitutional unit represented by Formula EV-2 do not correspond to the polymer compound 1.

### [Weight-average molecular weight]

From the viewpoints of the developability of the planographic printing plate precursor and the printing durability and the chemical resistance of the planographic printing plate to be obtained, the weight-average molecular weight of the polymer compound 1 is preferably in a range of 5000 to 300000, more preferably in a range of 10000 to 200000, and still more preferably in a range of 30000 to 100000.

### [Content]

The content of the polymer compound 1 is preferably in a range of 10% by mass to 90% by mass, more preferably in a range of 20% by mass to 80% by mass, and still more preferably in a range of 40% by mass to 70% by mass. In a case where the content thereof is in the above-described range, the pattern formability at the time of development is improved. Further, the total solid content of the image recording layer indicates the amount obtained by removing volatile components such as a solvent.

### <Polymer compound 2-1>

The image recording layer in the present disclosure contains the polymer compound 2-1 or the polymer compound 2-2.

From the viewpoint of shortening the non-image area development time, it is preferable that the image recording layer in the present disclosure contains the polymer compound 2-1.

From the viewpoint of the printing durability, it is preferable that the image recording layer in the present disclosure contains the polymer compound 2-2.

### [Constitutional unit represented by Formula S-1 or Formula S-2]

The polymer compound 2-1 has at least one of a constitutional unit represented by Formula S-1 or a constitutional unit represented by Formula S-2, and it is preferable that the compound 2-1 contains a constitutional unit represented by Formula S-1.

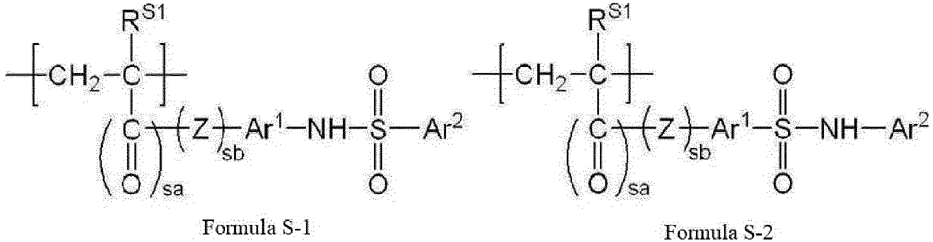

In Formulae S-1 and S-2, R^{S1} represents a hydrogen atom or an alkyl group, Z represents -O- or -N(R^{S2}), R^{S2} represents a hydrogen atom, an alkyl group, an alkenyl group, or an alkynyl group, each of Ar¹ and Ar² independently represents an aromatic group, at least one of Ar¹ or Ar² is a heteroaromatic group, and each of sa and sb independently represents 0 or 1.

In Formula S-1, R^{S1} represents a hydrogen atom or an alkyl group. The alkyl group is a substituted or unsubstituted alkyl group, and an alkyl group that does not have a substituent is preferable. Examples of the alkyl group represented by R^{S1} include lower alkyl groups such as a methyl group, an ethyl group, a propyl group, and a butyl group. It is preferable that R^{S1} is a hydrogen atom or a methyl group.

Z represents -O- or -N(R^{S2})- and preferably -N(R^{S2})-. Here, R^{S2} represents a hydrogen atom, an alkyl group, an alkenyl group, or an alkynyl group, preferably a hydrogen atom or an alkyl group which does not have a substituent, and more preferably a hydrogen atom.

Each of sa and sb independently represents 0 or 1. It is preferable that sa represents 0 and sb represents 1, both of sa and sb represent 0, or both of sa and sb represent 1 and most preferable that both of sa and sb represent 1.

More specifically, in the constitutional unit described above, it is preferable that Z represents -O- in a case where sa represents 0 and sb represents 1. Further, it is preferable that Z represents -N(R^{S2})-, and R^{S2} here represents a hydrogen atom in a case where both of sa and sb represent 1.

Each of Ar¹ and Ar² independently represents an aromatic group and at least one of Ar¹ or Ar² represents a heteroaromatic group. Ar¹ represents a divalent aromatic group and Ar² represents a monovalent aromatic group. These aromatic groups are each a substituent formed by replacing one or two hydrogen atoms constituting an aromatic ring with a linking group.

Such an aromatic group may be selected from hydrocarbon aromatic rings such as benzene, naphthalene, and anthracene and may be selected from heteroaromatic rings such as furan, thiophene, pyrrole, imidazole, 1,2,3-triazole, 1,2,4-triazole, tetrazole, oxazole, isoxazole, thiazole, isothiazole, thiadiazole, oxadiazole, pyridine, pyridazine, pyrimidine, pyrazine, 1,3,5-triazine, 1,2,4-triazine, and 1,2,3-triazine.

Further, a plurality of these rings may be fused to be formed into fused rings such as benzofuran, benzothiophene, indole, indazole, benzoxazole, quinoline, quinazoline, benzoimidazole, and benzotriazole.

These aromatic groups and heteroaromatic groups may further have a substituent, and examples of the substituent which can be introduced include an alkyl group, a cycloalkyl group, an alkenyl group, a cycloalkenyl group, an aryl group, a heteroaryl group, a hydroxy group, -SH, a carboxylic acid group or alkyl ester thereof, a sulfonic acid group or alkyl ester thereof, a phosphinic acid group or alkyl ester thereof, an amino group, a sulfonamide group, an amide group, a nitro group, a halogen atom, and a substituent formed by a plurality of these being bonded to one another. Further, these substituents may further have substituents exemplified here.

Ar² represents preferably a heteroaromatic group which may have a substituent and more preferably a heteroaromatic ring containing a nitrogen atom, which is selected from pyridine, pyridazine, pyrimidine, pyrazine, 1,3,5-triazine, 1,2,4-triazine, 1,2,3-triazine, tetrazole, oxazole, isoxazole, thiazole, isothiazole, thiadiazole, and oxadiazole.

Hereinafter, examples of monomers (exemplary monomers (A-1) to (A-27)) which can form a constitutional unit represented by Formula S-1 or S-2 will be shown, but the present disclosure is not limited thereto. Among these exemplary monomers shown below, a monomer containing a linking group which is -SO₂-NH- in the main chain side (for example, a monomer (A-1)) is a monomer which can form a constitutional unit represented by Formula S-1, and a monomer containing a linking group which is -NH-SO₂- in the main chain side (for example, a monomer (A-12)) is a monomer which can form a constitutional unit represented by Formula S-2.

Further, in the examples shown below, Me represents a methyl group.

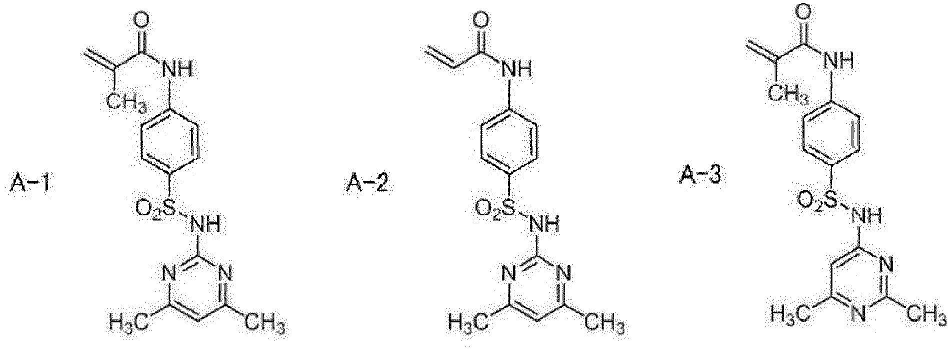

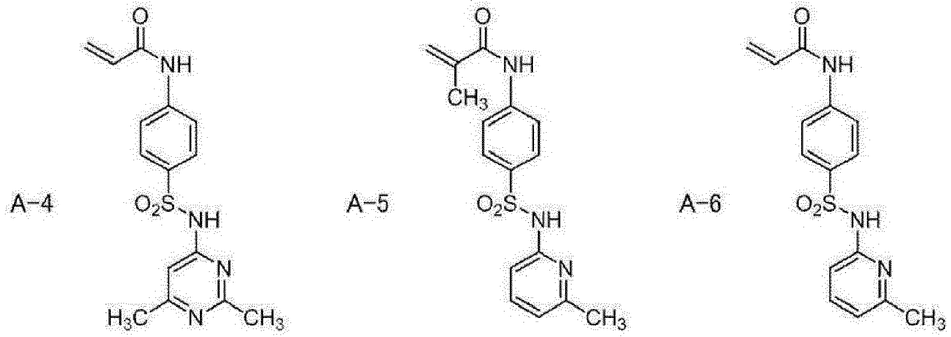

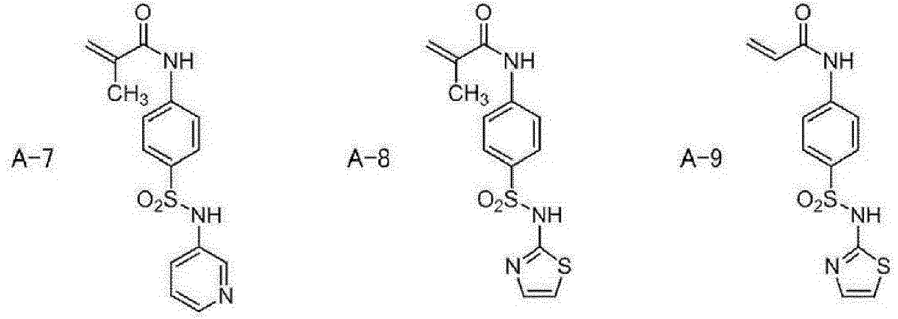

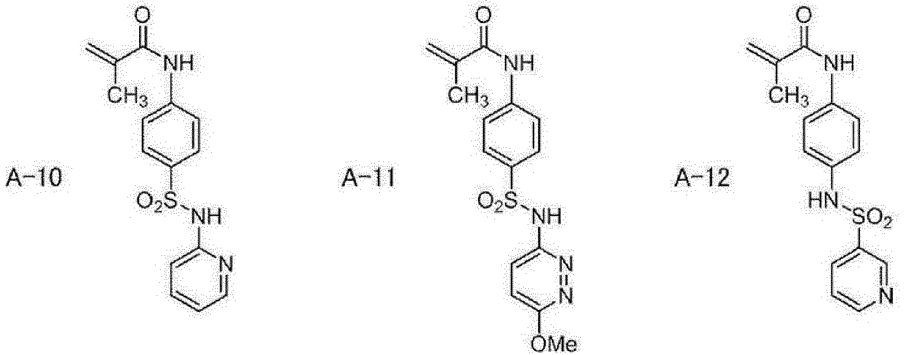

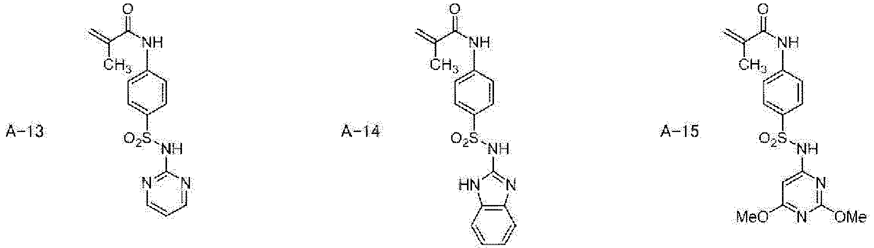

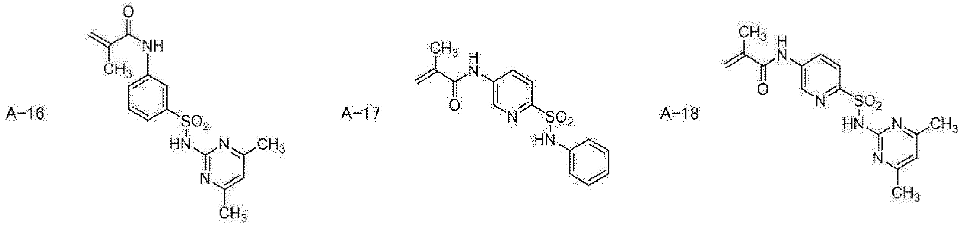

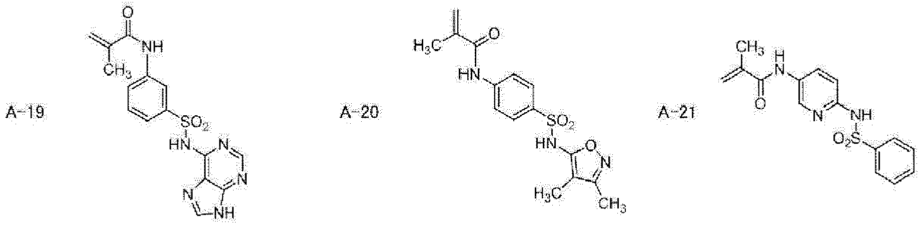

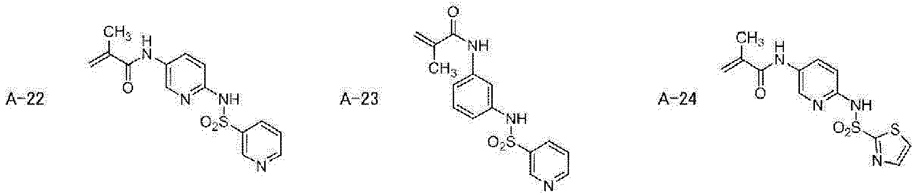

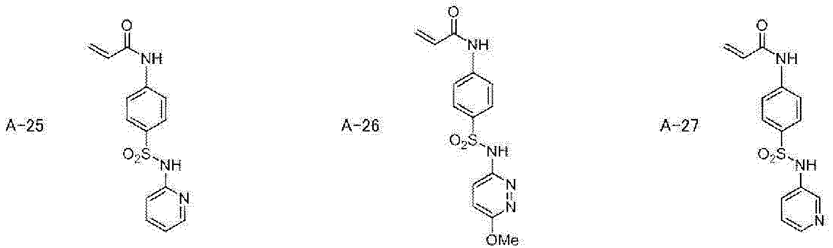

It is preferable that the polymer compound 2-1 is an alkali-soluble polymer containing at least one of a constitutional unit represented by Formula S-1 or a constitutional unit represented by Formula S-2. The polymer compound 2-1 may contain a single constitutional unit represented by Formula S-1 or S-2 or a combination of two or more kinds thereof.

The content of the constitutional unit (here, converted in the monomer unit) represented by Formula S-1 or S-2 is preferably in a range of 10% by mole to 100% by mole, more preferably in a range of 20% by mole to 90% by mole, still more preferably in a range of 30% by mole to 80% by mole, and most preferably in a range of 30% by mole to 70% by mole with respect to the total amount of the monomer units in the polymer compound 2-1.

### - Other constitutional units -

The polymer compound 2-1 may be a copolymer containing constitutional units other than the constitutional unit represented by Formula S-1 or S-2. Examples of other constitutional units include a constitutional unit derived from a hydrophobic monomer containing a substituent such as an alkyl group or an aryl group in a side chain structure of the monomer and a constitutional unit derived from a hydrophilic monomer containing an acidic group, an amide group, a hydroxy group, or an ethylene oxide group in the side chain structure of the monomer, and can be appropriately selected from these depending on the purpose thereof. Further, the kinds of monomers to be copolymerized need to be selected within a range not damaging the alkali-solubility of the polymer compound 2-1.

Examples of other copolymerization components which can be used in the polymer compound 2-1 according to the present disclosure include (meth)acrylamide, N-substituted (meth)acrylamide, N-substituted maleimide, (meth)acrylic acid ester, (meth)acrylic acid ester having a polyoxyethylene chain, 2-hydroxyethyl (meth)acrylate, styrene, styrenesulfonic acid, o-, p-, or m-vinylbenzene acid, vinylpyridine, N-vinylcaprolactam, N-vinylpyrrolidone, (meth)acrylic acid, itaconic acid, maleic acid, glycidyl (meth)acrylate, hydrolyzed vinyl acetate, and vinylphosphonic acid. Among these, preferred examples of copolymerization components include N-benzyl (meth)acrylamide and (meth)acrylic acid.

Hereinafter, examples of monomers (exemplary monomers (A-28) to (A-47)) which can form constitutional units of other copolymerization components will be shown.

Further, in the examples shown below, Me represents a methyl group, and Et represents an ethyl group.

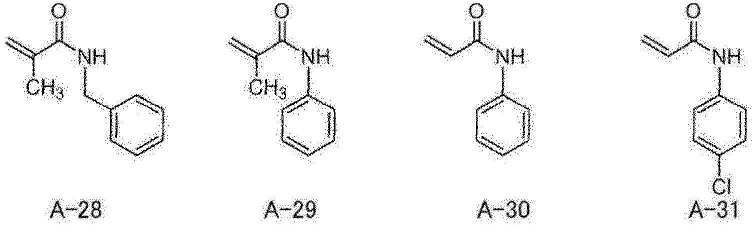

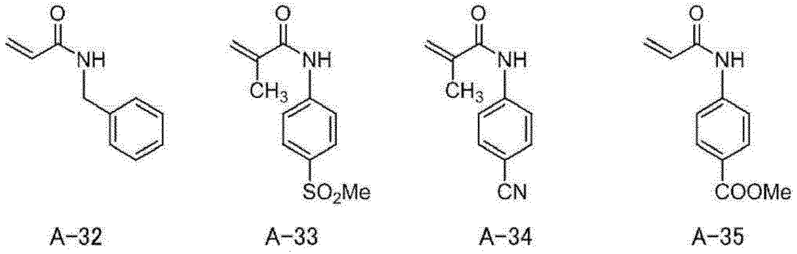

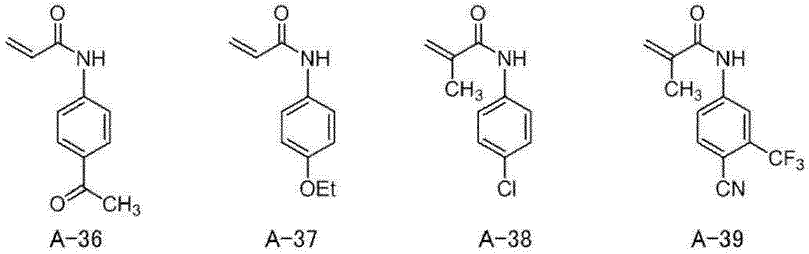

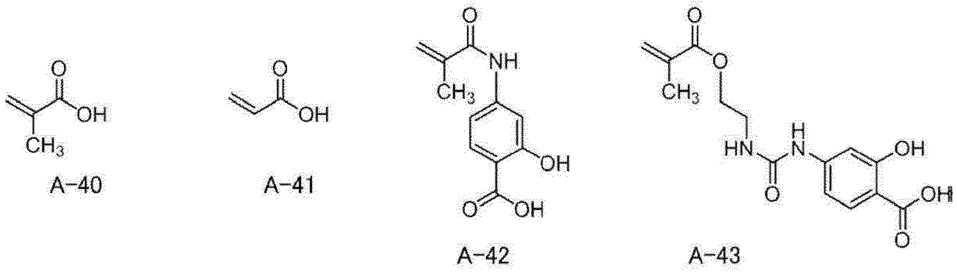

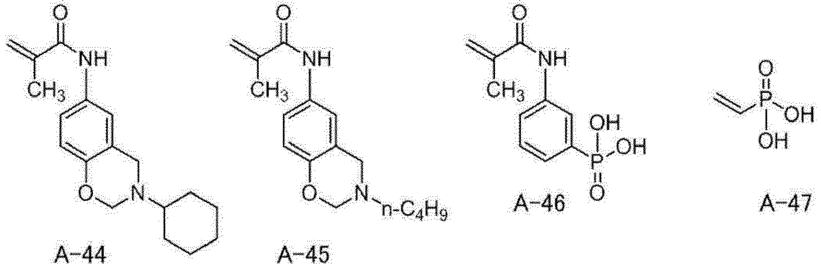

### - Molecular weight -

The number average molecular weight (Mn) of the polymer compound 2-1 is preferably in a range of 10000 to 500000, more preferably in a range of 10000 to 200000, and most preferably in a range of 10000 to 100000. Further, the weight-average molecular weight (Mw) thereof is preferably in a range of 10000 to 1000000, more preferably in a range of 20000 to 500000, and most preferably in a range of 20000 to 200000.

Hereinafter, examples of the configurations of the polymer compound 2-1 which can be suitably used for the planographic printing plate precursor according to the embodiment of the present disclosure are described below based on each combination of constitutional units. Further, the polymer compound 2-1 used in the present disclosure is not limited thereto.

**[Table 3]**

| Polymer compound 2-1 | Monomer-1 (molar ratio thereof contained) | Monomer-2 (molar ratio thereof contained) | Monomer-3 (molar ratio thereof contained) | Weight-average molecular weight (ten thousand) |
|---|---|---|---|---|
| PA-1 | A-1 | A-32 | A-41 | 6.6 |
| | 50 | 10 | 10 | |
| PA-2 | A-1 | A-32 | A-41 | 6.7 |
| | 54 | 44 | 2 | |
| PA-3 | A-1 | A-32 | A-41 | 8.1 |
| | 40 | 50 | 10 | |
| PA-4 | A-4 | A-32 | A-41 | 16.6 |
| | 54 | 44 | 2 | |
| PA-5 | A-7 | A-32 | A-41 | 4.5 |
| | 54 | 44 | 2 | |
| PA-6 | A-5 | A-32 | A-41 | 5.5 |
| | 54 | 44 | 2 | |
| PA-7 | A-8 | A-32 | A-41 | 3.1 |
| | 40 | 50 | 10 | |
| PA-8 | A-17 | A-32 | A-41 | 6.9 |
| | 50 | 40 | 10 | |
| PA-9 | A-1 | A-30 | A-44 | 5.6 |
| | 62 | 33 | 5 | |
| PA-10 | A-1 | A-30 | A-46 | 4.5 |
| | 60 | 35 | 5 | |
| PA-11 | A-1 | A-30 | A-47 | 3.9 |
| | 52 | 40 | 8 | |
| PA-12 | A-1 | A-30 | A-43 | 4.2 |
| | 50 | 45 | 5 | |

### - Content -

In a case where the image recording layer according to the present disclosure contains the polymer compound 2-1, the content of the polymer compound 2-1 is preferably in a range of 10% by mass to 90% by mass, more preferably in a range of 20% to 80% by mass, and still more preferably in a range of 30% by mass to 80% by mass with respect to the total mass of the image recording layer.

### <Polymer compound 2-2>

### [Constitutional unit represented by Formula EV-1 and constitutional unit represented by Formula EV-2]

The polymer compound 2-2 used in the present disclosure contains a constitutional unit represented by Formula EV-1 and a constitutional unit represented by Formula EV-2.

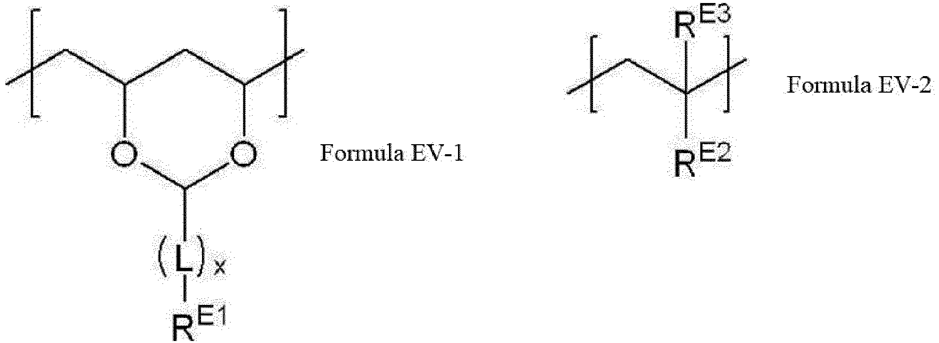

In Formula EV-1 or EV-2, L represents a divalent linking group, x represents 0 or 1, R^{E1} represents an aromatic ring or heteroaromatic ring which contains at least one hydroxy group, and each of R^{E2} and R^{E3} independently represents a hydrogen atom, a halogen atom, a linear, branched, or cyclic alkyl group which may have a substituent, a linear, branched, or cyclic alkenyl group which may have a substituent, an aromatic ring which may have a substituent, or a heteroaromatic ring which may have a substituent.

In Formula EV-1, R^{E1} represents an aromatic ring or heteroaromatic ring which contains at least one hydroxy group, and the hydroxy group may be contained in any of the ortho-, meta-, or para-position with respect to the bonding site with L.

Preferred examples of the aromatic ring include a phenyl group, a benzyl group, a tolyl group, an o-, m-, or p-xylyl group, a naphthyl group, an anthracenyl group, and a phenanthrenyl group.

Preferred examples of the heteroaromatic ring include a furyl group, a pyridyl group, a pyrimidyl group, a pyrazoyl group, and a thiophenyl group.

These aromatic rings or heteroaromatic rings may have a substituent other than a hydroxyl group, and examples of the substituent include an alkyl group such as a methyl group or an ethyl group, an alkoxy group such as a methoxy group or an ethoxy group, an azo group such as an aryloxy group, a thioalkyl group, a thioaryl group, -SH, an azoalkyl group or an azophenyl group, a thioalkyl group, an amino group, an ethenyl group, an alkenyl group, an alkynyl group, a cycloalkyl group, an aryl group, a heteroaryl group, and a heteroalicyclic group.

R^{E1} represents preferably a hydroxyphenyl group or hydroxynaphthyl group which contains a hydroxy group and more preferably a hydroxyphenyl group.

Examples of the hydroxyphenyl group include a 2-hydroxyphenyl group, a 3-hydroxyphenyl group, and a 4-hydroxyphenyl group.

Examples of the hydroxynaphthyl group include a 2,3-dihydroxynaphthyl group, a 2,4-dihydroxynaphthyl group, a 2,5-dihydroxynaphthyl group, a 1,2,3-trihydroxynaphthyl group, and a hydroxynaphthyl group.

A hydroxyphenyl group or a hydroxynaphthyl group may have a substituent, and preferred examples of the substituent include an alkoxy group such as a methoxy group and an ethoxy group.

In Formula EV-1, L represents a divalent linking group and preferably an alkylene group, an arylene group, a heteroarylene group, -O-, -C(=O)-, -C(=O)O-, -C(=O)-NH-, -NH-C(=O)-, -NH-C(=O)-O-, -O-C(=O)-NH-, -NH-C(=O)-NH-, -NH-C(=S)-NH-, -S(=O)-, -S(=O)₂-, -CH=N-, -NH-NH-, or a group represented by any of these bonds.

The alkylene group, the arylene group, or a heteroarylene group may have a substituent, and examples of the substituent include an alkyl group, a hydroxy group, an amino group, a monoalkylamino group, a dialkylamino group, an alkoxy group, and a phosphonic acid group or a salt thereof.

L represents more preferably an alkylene group, an arylene group, or a heteroarylene group and still more preferably -CH₂-, -CH₂-CH₂-, -CH₂-CH₂-CH₂-, or a phenylene group.

It is more preferable that the constitutional unit represented by Formula EV-1 is a constitutional unit represented by Formula EV-1A.

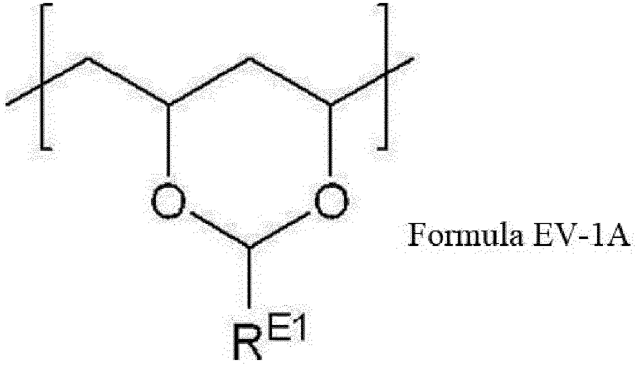

In Formula EV-1A, R^{E1} has the same definition as that for R^{E1} in Formula EV-1 and the preferable aspects thereof are the same as described above.

In Formula EV-2, each of R^{E2} and R^{E3} independently represents a hydrogen atom, a halogen atom, a linear, branched, or cyclic alkyl group which may have a substituent, a linear, branched, or cyclic alkenyl group which may have a substituent, an aromatic ring which may have a substituent, or a heteroaromatic ring which may have a substituent.

Examples of the alkyl group include a methyl group, an ethyl group, an n-propyl group, an n-butyl group, an n-pentyl group, an n-hexyl group, a chloromethyl group, a trichloromethyl group, an isopropyl group, an isobutyl group, an isopentyl group, a neopentyl group, a 1-methoxybutyl group, an isohexyl group, a cyclopropyl group, a cyclobutyl group, a cyclopentyl group, a cyclohexyl group, and a methylcyclohexyl group.

Examples of the alkenyl group include an ethenyl group, an n-propenyl group, an n-butenyl group, an n-pentenyl group, an n-hexenyl group, an isopropenyl group, an isobutenyl group, an isopentenyl group, a neopentenyl group, a 1-methylbutenyl group, an isohexenyl group, a cyclopentenyl group, a cyclohexenyl group, and a methylcyclohexenyl group.

Examples of the halogen atom include a chlorine atom.

Preferred examples of the aromatic ring include an aryl group such as a phenyl group, a benzyl group, a tolyl group, an o-, m-, or p-xylyl group, a naphthyl group, an anthracenyl group, or a phenanthrenyl group.

Examples of the heteroaromatic ring include a furyl group, a pyridyl group, a pyrimidyl group, a pyrazoyl group, and a thiophenyl group.

Each of R^{E2} and R^{E3} independently represents preferably a hydrogen atom, a chlorine atom, or a methyl group and more preferably a hydrogen atom.

Examples of the substituent in the alkyl group, alkenyl group, aromatic ring, or heteroaromatic ring include an alkoxy group such as a methoxy group or an ethoxy group, a thioalkyl group, and -SH.

The aromatic ring or heteroaromatic ring may contain an aryloxy group, a thioaryl group, an azo group such as an azoalkyl group or an azoaryl group, or an amino group, as a substituent.

It is more preferable that the constitutional unit represented by Formula EV-2 is a constitutional unit represented by Formula EV-2A.

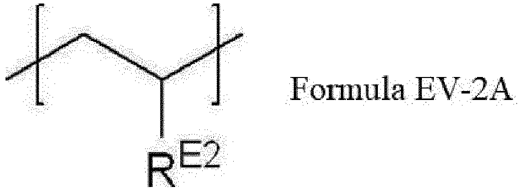

In Formula EV-2A, R^{E2} has the same definition as that for R^{E2} in Formula EV-2 and the preferable aspects thereof are the same as described above.

The content of the constitutional unit (here, converted in the monomer unit) represented by Formula EV-1 is preferably 10% by mole or greater, more preferably in a range of 10% by mole to 55% by mole, still more preferably in a range of 15% by mole to 45% by mole, and particularly preferably in a range of 20% by mole to 35% by mole with respect to the total amount of the monomer units in the polymer compound 2-2.

The content of the constitutional unit (here, converted in the monomer unit) represented by Formula EV-2 is preferably 15% by mole or greater, more preferably in a range of 15% by mole to 60% by mole, still more preferably in a range of 20% by mole to 50% by mole, and particularly preferably in a range of 25% by mole to 45% by mole with respect to the total amount of the monomer units in the polymer compound 2-2.

Further, the total content of the constitutional unit represented by Formula EV-1 and the constitutional unit represented by Formula EV-2 (here, converted in the monomer unit) is preferably in a range of 50% by mole to 90% by mole, more preferably in a range of 60% by mole to 80% by mole, and still more preferably in a range of 65% by mole to 75% by mole with respect to the total amount of the monomer units in the polymer compound 2-2.

### [Other constitutional units]

The polymer compound 2-2 may contain constitutional units other than the constitutional unit represented by Formula EV-1 and the constitutional unit represented by Formula EV-2.

Examples of other constitutional units include a constitutional unit derived from vinyl alcohol which is represented by Formula EV-3 and a constitutional unit represented by Formula EV-4.

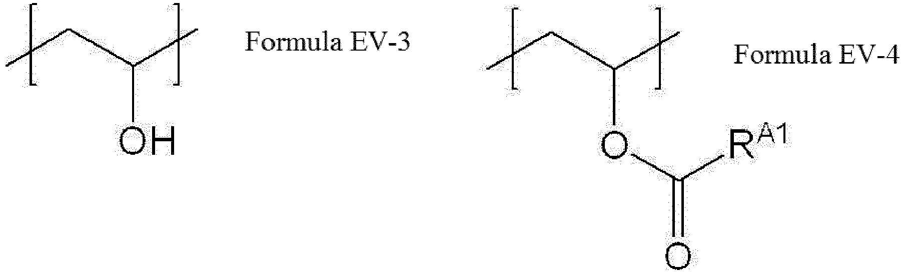

In Formula EV-4, R^{A1} represents a hydrogen atom, a linear, branched, or cyclic alkyl group which may have a substituent, an aromatic ring which may have a substituent, or a heteroaromatic ring which may have a substituent.

Examples of the substituent in the alkyl group, aromatic ring, or heteroaromatic ring include an alkoxy group such as a methoxy group or an ethoxy group, a thioalkyl group, and -SH.

Further, examples of the substituent in the aromatic ring or heteroaromatic ring aryloxy group include an aryloxy group, a thioaryl group, an azo group, and an amino group.

The content of the constitutional unit (here, converted in the monomer unit) represented by Formula EV-3 is preferably in a range of 10% by mole to 60% by mole, more preferably in a range of 15% by mole to 50% by mole, and still more preferably in a range of 20% by mole to 30% by mole with respect to the total amount of the monomer units in the polymer compound 2-2.

The content of the constitutional unit (here, converted in the monomer unit) represented by Formula EV-4 is preferably in a range of 0% to 10% by mole, more preferably 0% by mole or greater and less than 8% by mole, still more preferably 0% by mole or greater and less than 3% by mole, and particularly preferably 0% by mole or greater and less than 1% by mole with respect to the total amount of the monomer units in the polymer compound 2-2.

### [Preferable configurations]

Further, as the polymer compound 2-2, polyvinyl acetal represented by Formula VA is preferable.

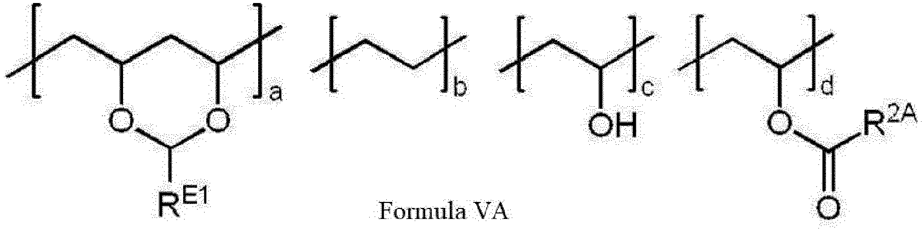

In Formula VA, R^{E1} represents an aromatic ring or heteroaromatic ring which contains at least one hydroxy group, R^{2A} represents an alkyl group which may have a substituent, a represents 10% by mole to 55% by mole, b represents 15% by mole to 60% by mole, c represents 10% by mole to 60% by mole, and d represents 0% by mole to 10% by mole.

In Formula VA, R^{E1} has the same definition as that for R^{E1} in Formula EV-1 and the preferable aspects thereof are the same as described above.

In Formula VA, R^{2A} represents an alkyl group which may have a substituent and preferably a methyl group.

In Formula VA, a represents preferably 20% by mole to 50% by mole and more preferably 25% by mole to 45% by mole.

In Formula VA, b represents preferably 15% by mole to 45% by mole and more preferably 20% by mole to 35% by mole.

In Formula VA, c represents preferably 15% by mole to 50% by mole and more preferably 20% by mole to 30% by mole.

In Formula VA, d represents preferably 0% by mole or greater and less than 3% by mole and more preferably 0% by mole or greater and less than 1% by mole.

Hereinafter, specific examples of the polymer compound 2-2 which is preferably used in the present disclosure will be described. In the specific example, Mn represents the number average molecular weight. Further, the polymer compound 2-2 used in the present disclosure is not limited thereto.

Further, the compounds in the following specific examples are not block copolymers but random copolymers randomly having constitutional units delimited by [ ].

Further, in the following examples, Me represents a methyl group.

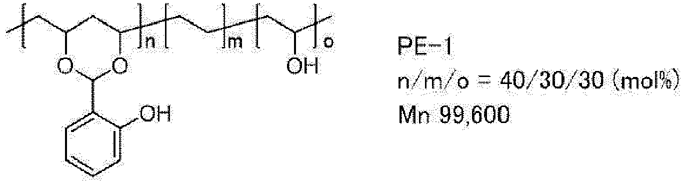

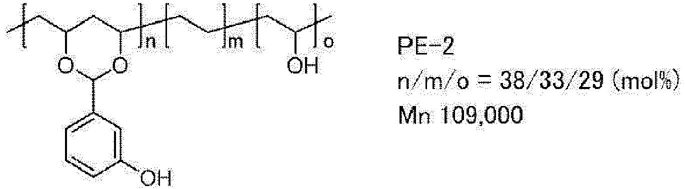

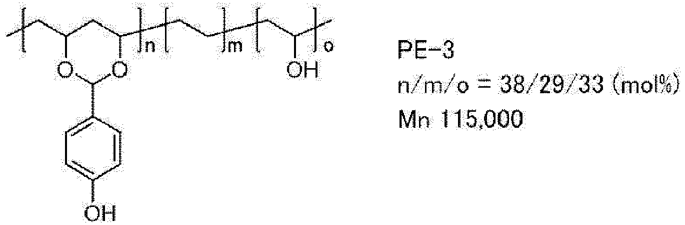

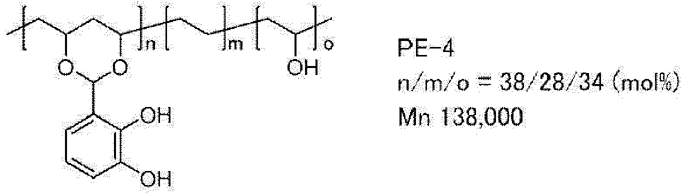

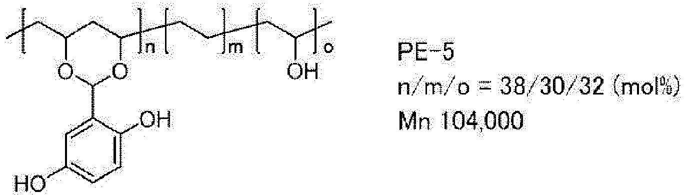

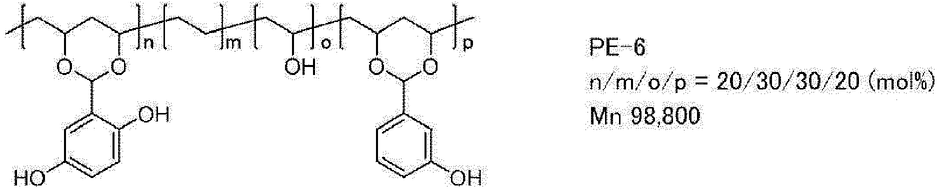

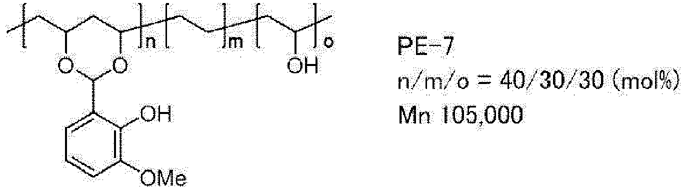

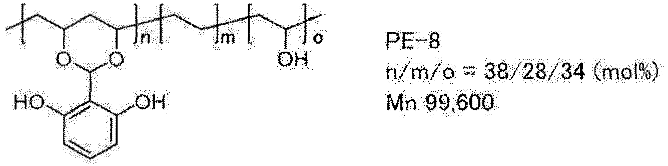

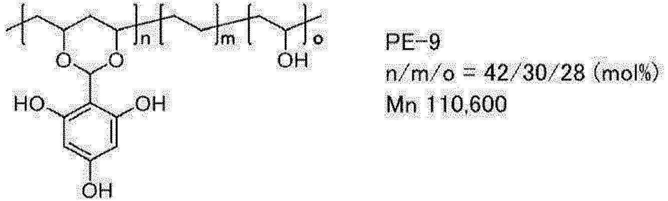

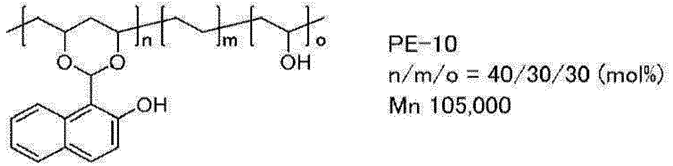

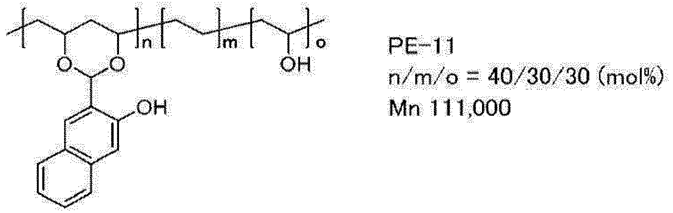

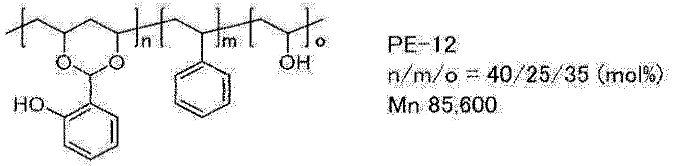

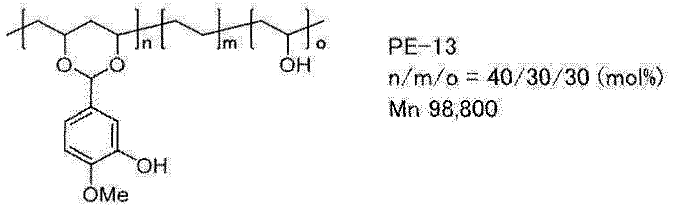

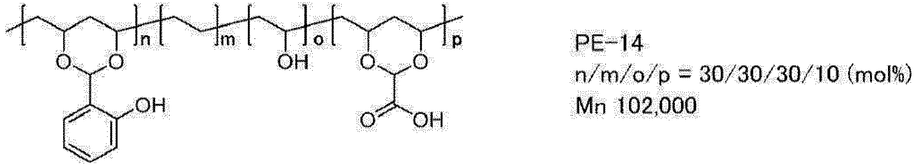

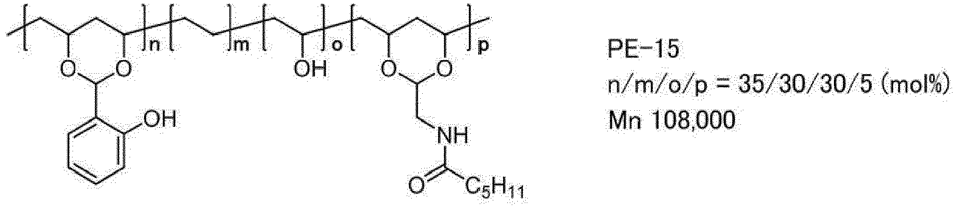

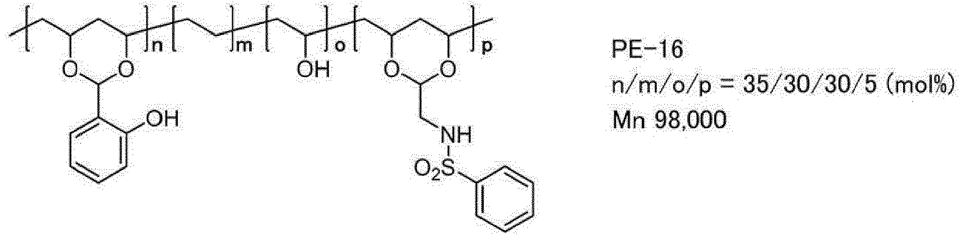

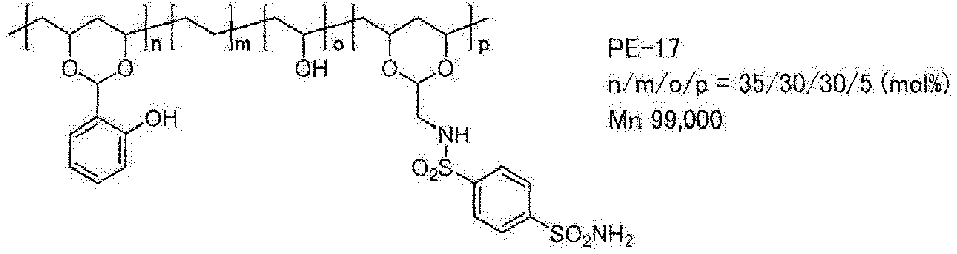

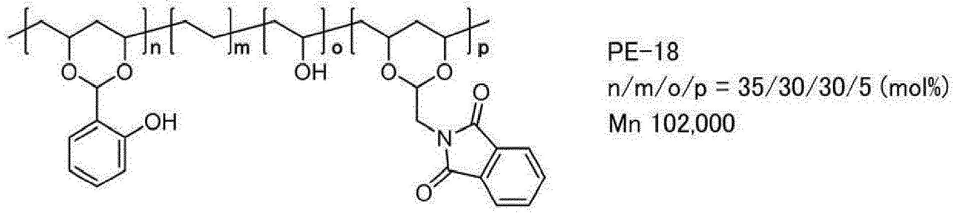

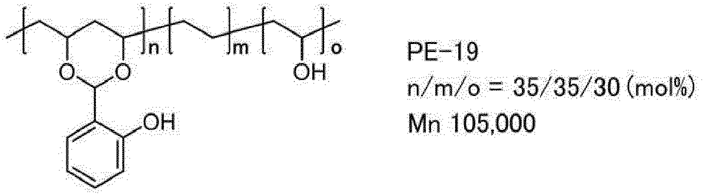

The number average molecular weight (Mn) of the polymer compound 2-2 used in the present disclosure is preferably 1500 or greater, more preferably in a range of 3000 to 300000, and still more preferably in a range of 10000 to 150000.

The polymer compound 2-2 according to the present disclosure may contain constitutional units other than the constitutional units represented by Formulae EV-1 and EV-2.

Examples of other constitutional units include constitutional units described in US5169897A, WO1993/003068A, US5534381A, US5698360A, JP1999-212252A (JP-H11-212252A), JP1999-231535A (JP-H11-231535A), JP2000-039707A, JP2000-275821A, JP2000-275823A, US6087066A, WO2001/009682A, US6270938B, US6596460B, WO2002/073315A, WO2002/096961A, US6818378B, WO2004/020484A, WO2007/003030A, WO2009/005582A, and WO2009/099518A.

The polymer compound 2-2 can be prepared using known starting materials and reaction conditions.

Examples of the method of preparing the polymer compound 2-2 include methods described in US6541181B, US4665124A, US4940646A, US5169898A, US5700619A, US5792823A, US5849842A, WO93/003068A, German Patent No. 10011096, German Patent No. 3404366, US09/751660A, WO01/009682A, WO03/079113A, WO2004/081662A, WO2004/020484A, WO2008/103258A, and JP1997-328519A (JP-H09-328519A).

### [Content]

In a case where the image recording layer according to the present disclosure contains the polymer compound 2-2, the content of the polymer compound 2-2 is preferably in a range of 10% by mass to 90% by mass, more preferably in a range of 20% by mass to 80% by mass, and still more preferably in a range of 30% by mass to 80% by mass with respect to the total mass of the image recording layer.

### <Infrared absorbent>

The image recording layer according to the present disclosure contains an infrared absorbent.

The infrared absorbent is not particularly limited as long as it is a dye which generates heat by absorbing infrared light, and various dyes known as an infrared absorbent can be used.

Examples of the infrared absorbent which can be used in the present disclosure include the infrared absorbents described in paragraphs 0075 to 0085 of WO2016/047392A.

Among these dyes, examples of a particularly preferable dye include a cyanine coloring agent, a phthalocyanine dye, an oxonol dye, a squarylium coloring agent, a pyrylium salt, a thiopyrylium dye, and a nickel thiolate complex. Furthermore, it is most preferable that a cyanine coloring agent represented by the following Formula (a) is used for the image recording layer of the positive type planographic printing plate precursor according to the embodiment of the present disclosure from the viewpoint that the dissolution suppressing action is satisfactorily released due to exposure and stability and economic efficiency are excellent.

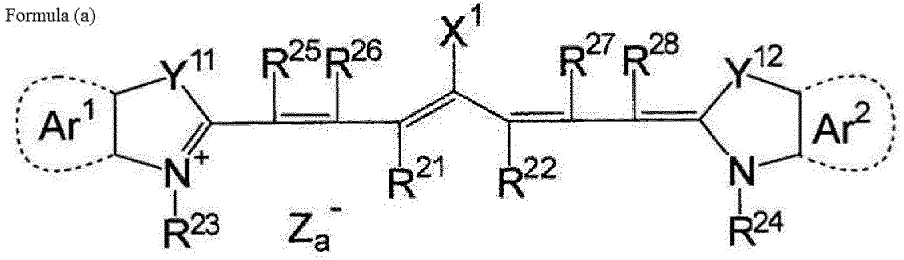

In Formula (a), X¹ represents a hydrogen atom, a halogen atom, a diarylamino group, X²-L¹, or a group shown represented by Formula (b). X² represents an oxygen atom or a sulfur atom, and L¹ represents a hydrocarbon group having 1 to 12 carbon atoms, an aromatic ring having a heteroatom, or a hydrocarbon group having 1 to 12 carbon atoms including a heteroatom. Here, the heteroatom represents N, S, O, a halogen atom, or Se.

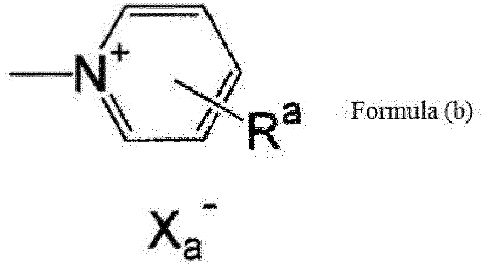

In Formula (b), Xa⁻ has the same definition as Za⁻ described below, and R^{a} represents a substituent selected from a hydrogen atom, an alkyl group, an aryl group, a substituted or unsubstituted amino group, and a halogen atom.

Each of R²¹ and R²² independently represents a hydrocarbon group having 1 to 12 carbon atoms. From the viewpoint of storage stability of the positive type planographic printing plate precursor, each of R²¹ and R²² is preferably a hydrocarbon group having two or more carbon atoms, and R²¹ and R²² are particularly preferably bonded to each other to form a 5-membered ring or a 6-membered ring.

Ar¹ and Ar² may be the same as or different from each other, and Ar¹ and Ar² each represent an aromatic hydrocarbon group which may have a substituent. Examples of a preferable aromatic hydrocarbon group include a benzene ring and a naphthalene ring. In addition, preferred examples of the substituent include a hydrocarbon group having 1 to 12 carbon atoms, a halogen atom, and an alkoxy group having 1 to 12 carbon atoms.

Y¹¹ and Y1² may be the same as or different from each other, and Y¹¹ and Y1² each represent a sulfur atom or a dialkyl methylene group having 3 to 12 carbon atoms. R²³ and R²⁴ may be the same as or different from each other, and R²³ and R²⁴ each represent a hydrocarbon group having 1 to 20 carbon atoms which may have a substituent. Preferred examples of the substituent include an alkoxy group having 1 to 12 carbon atoms, a carboxyl group, and a sulfo group.

R²⁵, R²⁶, R²⁷, and R²⁸ may be the same as or different from each other, and R²⁵, R²⁶, R²⁷, and R²⁸ each represent a hydrogen atom or a hydrocarbon group having 1 to 12 carbon atoms. From the viewpoint of availability of a raw material, it is preferable that R²⁵, R²⁶, R²⁷, and R²⁸ each represent a hydrogen atom. In addition, Za⁻ represents a counter anion. Here, the cyanine coloring agent represented by Formula (a) has an anionic substituent in the structure thereof, and in a case where neutralization of the charge is not necessary, Za⁻ is not necessary. From the viewpoint of storage stability of the positive type planographic printing plate precursor, Za⁻ represents preferably a halide ion, a perchlorate ion, a tetrafluoroborate ion, a hexafluorophosphate ion, or a sulfonic acid ion and particularly preferably a perchlorate ion, a hexafluorophosphate ion, or an arylsulfonic acid ion.

Specific examples of the cyanine coloring agent represented by Formula (a) which can be suitably used include the cyanine coloring agents described in paragraphs 0017 to 0019 of JP2001-133969A, paragraphs 0012 to 0038 of JP2002-040638A, and paragraphs 0012 to 0023 of JP2002-023360A. It is particularly preferable that the infrared absorbent contained is a cyanine dye A shown below.

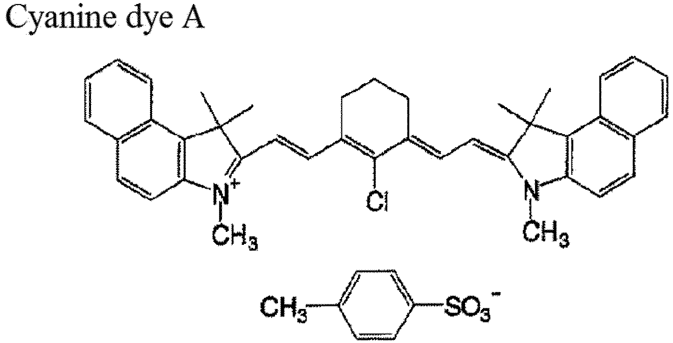

The content of the infrared absorbent in the image recording layer according to the present disclosure is preferably in a range of 0.01% by mass to 50% by mass, more preferably in a range of 0.1% by mass to 30% by mass, and particularly preferably in a range of 1.0% by mass to 30% by mass, with respect to the total mass of the image recording layer. In a case where the content thereof is 0.01% by mass or greater, the layer becomes highly sensitive, and in a case where the content thereof is 50% by mass or less, the uniformity of the layer is excellent and the durability of the layer is excellent.

### <Other alkali-soluble resins>

The image recording layer according to the present disclosure may contain alkali-soluble resins other than the polymer compound 1, the polymer compound 2-1, and the polymer compound 2-2.

In the present disclosure, the "alkali-soluble" means that "0.01 g of a resin is dissolved in 5 g of a sodium hydroxide aqueous solution having a pH of 13.0 at 30°C within 200 seconds. Further, the dissolution indicates is a state in which the residual of a dissolved substance cannot be visually confirmed.

Although other alkali-soluble resins used in the image recording layer of the present disclosure is not particularly limited as long as the resin has a characteristic of being dissolved by contact with an alkaline developer, it is preferable that the alkali-soluble resin has an acidic functional group such as a sulfonic acid group, a phosphoric acid group, a sulfonamide group, or an active imide group in at least one of the main chain or a side chain in the polymer, a resin including 10% by mole or greater of a monomer having such an acidic functional group imparting alkali-solubility is exemplified, and a resin including 20% by mole or greater is more preferable. In a case where the copolymerization component of the monomer imparting alkali-solubility is 10% by mole or greater, sufficient alkali-solubility is obtained, and developability is excellent.

In addition, as other alkali-soluble resin, a novolac resin is also preferably exemplified.

Preferred examples of the novolac resin which can be used in the image recording layer of the present disclosure, novolac resins such as a phenol formaldehyde resin, an m-cresol formaldehyde resin, a p-cresol formaldehyde resin, an m-/p- mixed cresol formaldehyde resin, a phenol/cresol (which may be any mixture of m-, p-, or m-/p-) mixed formaldehyde resin or pyrogallol acetone resins are preferably exemplified.

In addition, a polycondensate of phenol having an alkyl group having 3 to 8 carbon atoms as a substituent and formaldehyde, such as a t-butyl phenol formaldehyde resin or an octyl phenol formaldehyde resin, as described in US4123279A, is exemplified. In addition, the weight-average molecular weight (Mw) thereof is preferably 500 or greater, and more preferably 1,000 to 700,000. In addition, the number average molecular weight (Mn) thereof is preferably 500 or greater, and more preferably 750 to 650,000. The dispersity (weight-average molecular weight/number average molecular weight) is preferably 1.1 to 10.

Other alkali-soluble resins preferably have a weight-average molecular weight of 2,000 or greater and a number average molecular weight of 500 or greater, and more preferably have a weight-average molecular weight of 5,000 to 300,000 and a number average molecular weight of 800 to 250,000. The dispersity (weight-average molecular weight/number average molecular weight) of other alkali-soluble resins is preferably 1.1 to 10.

Other alkali-soluble resins included in the image recording layer according to the present disclosure as desired may be used alone or in combination of two or more kinds thereof.

The content of other alkali-soluble resins in the image recording layer according to the present disclosure is preferably 0% by mass to 80% by mass and more preferably 0% by mass to 70% by mass with respect to the total mass of the image recording layer. In addition, the proportion of other alkali-soluble resin is preferably 80 parts by mass or less with respect to 100 parts by mass which is the total amount of the polymer compounds 1, 2-1, and 2-2 used in the image recording layer according to the present disclosure.

### <Acid generator>

It is preferable that the image recording layer according to the present disclosure contains an acid generator from the viewpoint of improving the sensitivity.

The acid generator in the present disclosure is a compound which generates an acid by light or heat, and indicates a compound which generates an acid due to decomposition by irradiation with infrared rays or heating at 100°C or higher. The acid generated is preferably a strong acid having a pKa of 2 or less such as sulfonic acid or hydrochloric acid. The permeability of a developer into the image recording layer of the exposed portion is increased and the solubility of the image recording layer in an alkali aqueous solution is further improved due to an acid generated from this acid generator.

Examples of the acid generator which is suitably used in the image recording layer according to the present disclosure include the acid generators described in paragraphs 0116 to 0130 of WO2016/047392A.

Among these, from the viewpoint of sensitivity and stability, an onium salt compound is preferably used as an acid generator. The onium salt compound will be described below.

As the onium salt compound which can be suitably used in the image recording layer according to the present disclosure, compounds known as a compound which generates an acid due to decomposition by infrared ray exposure or heat energy generated from the infrared absorbent by exposure can be exemplified. As the onium salt compound suitable in the image recording layer according to the present disclosure, from the viewpoint of sensitivity, known thermal polymerization initiators or compounds having a bond with small bond dissociation energy and having an onium salt structure described below can be exemplified.

Examples of the onium salt suitably used in the image recording layer according to the present disclosure include known diazonium salts, iodonium salts, sulfonium salts, ammonium salts, pyridinium salts, and azinium salts, and among these, sulfonate of triarylsulfonium or diaryliodonium, carboxylate, BF₄⁻, PF₆⁻, or ClO₄⁻ is preferable.

Examples of the onium salt which can be used as an acid generator in the image recording layer of the positive type planographic printing plate precursor according to the embodiment of the present disclosure include onium salts represented by the following Formulae (III) to (V).

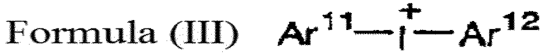

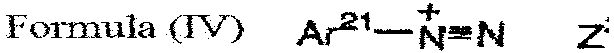

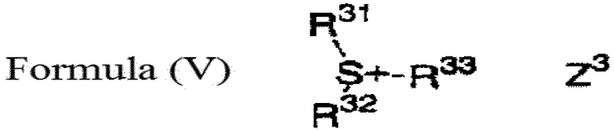

In Formula (III), each of Ar¹¹ and Ar¹² independently represents an aryl group having 6 to 20 carbon atoms which may have a substituent. Examples of a preferable substituent in a case where the aryl group has a substituent include a halogen atom, a nitro group, an alkyl group having 1 to 12 carbon atoms, an alkoxy group having 1 to 12 carbon atoms, and an aryloxy group having 1 to 12 carbon atoms. Z¹¹⁻ represents a counter ion selected from the group consisting of a halide ion, a perchlorate ion, a tetrafluoroborate ion, a hexafluorophosphate ion, a sulfonic acid ion, or a sulfonic acid ion having a fluorine atom such as a perfluoroalkyl sulfonic acid ion, and a perchlorate ion, a hexafluorophosphate ion, an aryl sulfonic acid ion, or a perfluoroalkyl sulfonic acid is preferable.

In Formula (IV), Ar²¹ represents an aryl group having 6 to 20 carbon atoms which may have a substituent. Examples of a preferable substituent include a halogen atom, a nitro group, an alkyl group having 1 to 12 carbon atoms, an alkoxy group having 1 to 12 carbon atoms, an aryloxy group having 1 to 12 carbon atoms, an alkylamino group having 1 to 12 carbon atoms, a dialkylamino group having 2 to 12 carbon atoms, an arylamino group having 6 to 12 carbon atoms, and a diarylamino group (each independently having 6 to 12 carbon atoms in the aryl group). Z²¹⁻ represents a counter ion having the same definition as that for Z¹¹⁻.

In Formula (V), R³¹, R³², and R³³ may be the same as or different from each other, and R³¹, R³², and R³³ each represent a hydrocarbon group having 1 to 20 carbon atoms which may have a substituent. Examples of a preferable substituent include a halogen atom, a nitro group, an alkyl group having 1 to 12 carbon atoms, an alkoxy group having 1 to 12 carbon atoms, and an aryloxy group having 1 to 12 carbon atoms. Z³¹⁻ represents a counter ion having the same definition as that for Z¹¹⁻.

Specific examples of the onium salt which can be suitably used in the image recording layer according to the present disclosure are the same as the compounds described in paragraphs 0121 to 0124 of WO2016/047392A.

In addition, as another example of the compounds represented by each of Formula (III) to (V), the compounds described as an example of a radical polymerization initiator in paragraphs 0036 to 0045 of JP2008-195018A can be suitably used as an acid generator in the image recording layer according to the present disclosure.

More preferred examples of the acid generator which can be used in the image recording layer according to the present disclosure include compounds represented by Formulae PAG-1 to PAG-5. Further, in Formulae PAG-1 to PAG-5, Me represents a methyl group.

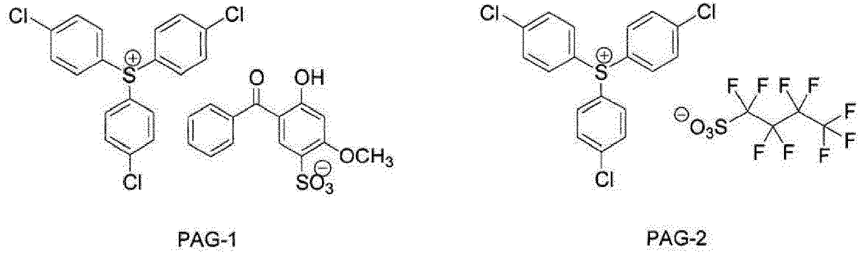

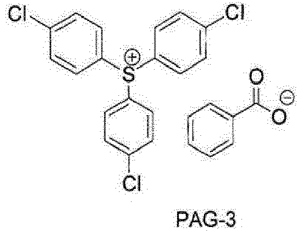

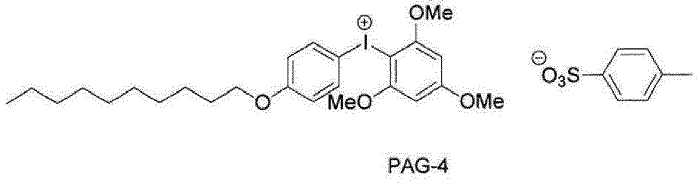

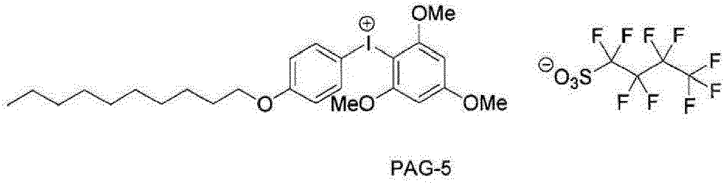

In a case where these acid generators are contained in the image recording layer according to the present disclosure, these compounds may be used alone or in combination of two or more kinds thereof.

The content of acid generator is preferably in a range of 0.01% by mass to 50% by mass, more preferably in a range of 0.1% by mass to 40% by mass, and still more preferably in a range of 0.5% by mass to 30% by mass with respect to the total mass of the image recording layer. In a case where the content is within the above-described range, improvement of sensitivity which is the effect of the addition of an acid generator is observed, and an occurrence of a residual film in a non-image area is suppressed.

### <Acid proliferation agent>

An acid proliferation agent may be contained in the image recording layer according to the present disclosure. The acid proliferation agent in the image recording layer according to the present disclosure is a compound substituted with a residue of a relatively strong acid, and a compound which newly generates an acid by being easily released in the presence of an acid catalyst. That is, the compound is decomposed by an acid catalyzed reaction, and generates an acid again. Since one or more acids per reaction are increased, and with the progress of the reaction, the acid concentration is increasingly increased, sensitivity is dramatically improved. The intensity of this generated acid preferably is 3 or less as an acid dissociation constant (pKa) and more preferably 2 or less. In a case where the intensity of the acid is 3 or less as an acid dissociation constant, the elimination reaction using an acid catalyst is likely to be caused.

Examples of the acid used in such an acid catalyst include dichloroacetic acid, trichloroacetic acid, methanesulfonic acid, ethanesulfonic acid, benzenesulfonic acid, p-toluenesulfonic acid, naphthalenesulfonic acid, and phenyl sulfonic acid.

Examples of the acid proliferation agent which can be used are the same as those described in paragraphs 0133 to 0135 of WO2016/047392A.

The content of the acid proliferation agent is in a range of 0.01% by mass to 20% by mass, preferably in a range of 0.01% by mass to 10% by mass, and more preferably in a range of 0.1% by mass to 5% by mass with respect to the total mass of the image recording layer according to the present disclosure. In a case where the content of the acid proliferation agent is in the above-described range, effects of adding acid proliferation agent are sufficiently obtained, improvement in sensitivity is achieved, and film hardness reduction of an image area is suppressed.

### <Other additives>

The image recording layer according to the present disclosure may include a development accelerator, a surfactant, a print-out agent/colorant, a plasticizer, or a wax agent, as other additives. As other additives, those described in paragraphs 0138 to 0142 of WO2016/047392A can be used.

### <Compositional ratio of respective components>

The content of the polymer compound 1 is preferably 10% by mass to 90% by mass, the content of the polymer compound 2-1 or the polymer compound 2-2 is preferably in a range of 10% by mass to 90% by mass, the content of the infrared absorbent is preferably in a range of 0.01% by mass to 50% by mass, the content of other alkali-soluble resins is preferably 0% by mass to 80% by mass, the content of the acid generator is preferably 0% by mass to 30% by mass, the content of the acid proliferation agent is preferably 0% by mass to 20% by mass, the content of the development accelerator is preferably 0% by mass to 20% by mass, the content of the surfactant is preferably 0% by mass to 5% by mass, the content of the print-out agent/colorant is preferably 0% by mass to 10% by mass, the content of the plasticizer is preferably 0% by mass to 10% by mass, and the content of the wax agent is preferably 0% by mass to 10% by mass, with respect to the total mass of the image recording layer according to the present disclosure.

In a case where the image recording layer according to the present disclosure contains the polymer compound 2-1, the content ratio (mass ratio) between the polymer compound 1 and the polymer compound 2-1 (polymer compound 1:polymer compound 2-1) which are contained in the image recording layer according to the present disclosure is preferably in a range of 1:9 to 9:1, more preferably in a range of 1:5 to 5:1, and particularly preferably in a range of 1:3 to 3:1.

In a case where the image recording layer according to the present disclosure contains the polymer compound 2-2, the content ratio (mass ratio) between the polymer compound 1 and the polymer compound 2-2 (polymer compound 1:polymer compound 2-2) which are contained in the image recording layer according to the present disclosure is preferably in a range of 1:9 to 9:1, more preferably in a range of 1:5 to 5:1, and particularly preferably in a range of 1:3 to 3:1.

### <Upper layer and lower layer>

It is preferable that the positive type planographic printing plate precursor according to the embodiment of the present disclosure includes a recording layer having a lower layer and an upper layer in this order, on the support, and at least one of the lower layer or the upper layer is the image recording layer (the image recording layer containing the polymer compound 1, the polymer compound 2-1 or the polymer compound 2-2, and the infrared absorbent, and also referred to as the "image recording layer according to the present disclosure").

The positive type planographic printing plate precursor having the lower layer and the upper layer is also referred to as a "positive type planographic printing plate precursor having a two-layer structure".

In the present disclosure, the recording layer indicates a layer whose solubility in an alkali aqueous solution is changed due to heat. It is preferable that both of the lower layer and the upper layer are recording layers.

In a case where any one of the lower layer or the upper layer is the image recording layer according to the present disclosure, it is preferable that the other layer is another recording layer.

Another recording layer indicates a recording layer whose composition is different from the composition of the image recording layer according to the present disclosure, and it is preferable that another layer is a recording layer whose solubility in an alkali aqueous solution is improved due to heat.

In the positive type planographic printing plate precursor according to the embodiment of the present disclosure, from the viewpoint of the printing durability in a case where a particularly low-quality material such as paper or ink is used, it is preferable that the lower layer is the image recording layer according to the present disclosure and the upper layer is another recording layer.

The detailed mechanism for obtaining the above-described effect is not clear, but it is assumed that the film hardness of the resin used in the lower layer is important for the printing durability in printing. Therefore, in the image recording layer according to the present disclosure, it is speculated that the printing durability is improved by using the image recording layer according to the present disclosure as the lower layer because the interaction (a hydrogen bond or the like) between binders is strong.

### [Formation of lower layer and upper layer]

It is preferable that the lower layer and the upper layer are separately formed.

As the method of separately forming the two layers, for example, a method of using the difference in the solvent solubilities between the components included in the lower layer and the components included in the upper layer and a method of rapidly drying and removing the solvent after application to the upper layer are exemplified. Since by using the latter method in combination, the separation between the layers is more favorably performed, the method is preferable.

These methods will be described in detail below, but the method of separately applying to the two layers is not limited thereto.

In the method of using the difference in the solvent solubilities between the components included in the lower layer and the components included in the upper layer, in a case where applying a coating solution for an upper layer, a solvent system in which all the components included in the lower layer are insoluble is used. Thus, even in a case where two-layer coating is performed, a coated film can be formed such that each layer thereof is clearly separated. For example, by selecting a component insoluble in a solvent such as methyl ethyl ketone or 1-methoxy-2-propanol which dissolves an alkali-soluble resin which is the upper layer component, as the lower layer component, applying to the lower layer and drying using a solvent system which dissolves the lower layer component, dissolving the alkali-soluble resin-based upper layer in methyl ethyl ketone or 1-methoxy-2-propanol, and applying the resulting product and drying, bilayering is possible.

Next, the method of very rapidly drying the solvent after application to the second layer (upper layer) can be achieved by blowing high-pressure air from a slit nozzle provided substantially at a right angle with respect to the running direction of the web, applying heat energy as conductive heat from the lower surface of the web by a roll (heating roll) into which a heating medium such as steam has been supplied, or combining these.

The coating amount after drying of the lower layer components to be applied to the support of the positive type planographic printing plate precursor according to the embodiment of the present disclosure is preferably in a range of 0.5 g/m² to 4.0 g/m² and more preferably in a range of 0.6 g/m² to 2.5 g/m². In a case where the coating amount is 0.5 g/m² or greater, printing durability is excellent, and in a case where the coating amount is 4.0 g/m² or less, image reproducibility and sensitivity are excellent.

In addition, the coating amount after drying of the upper layer component is preferably 0.05 g/m² to 1.0 g/m² and more preferably 0.08 g/m² to 0.7 g/m². In a case where the coating amount is 0.05 g/m² or greater, development latitude and scratch resistance are excellent, and in a case where the coating amount is 1.0 g/m² or less, sensitivity is excellent.

The coating amount after drying of the lower layer and the upper layer is preferably in a range of 0.6 g/m² to 4.0 g/m² and more preferably in a range of 0.7 g/m² to 2.5 g/m². In a case where the coating amount is 0.6 g/m² or greater, printing durability is excellent, and in a case where the coating amount is 4.0 g/m² or less, image reproducibility and sensitivity are excellent.

### [Upper layer]

The upper layer of the positive type planographic printing plate precursor having a two-layer structure according to the embodiment of the present disclosure may be the image recording layer according to the present disclosure, but it is preferable that the upper layer thereof is another recording layer.

It is preferable that the upper layer of the positive type planographic printing plate precursor having a two-layer structure according to the embodiment of the present disclosure is an infrared sensitive positive type recording layer whose solubility in an alkali aqueous solution is improved by heat.

The mechanism of improving the solubility in alkali aqueous solution by heat in the upper layer is not particularly limited, and any one can be used as long as it includes a binder resin and improves the solubility of the heated region. As the heat used in image formation, the heat generated in a case where the lower layer including an infrared absorbent is exposed is exemplified.

Preferable examples of the upper layer of which the solubility in an alkali aqueous solution is improved by heat include a layer including an alkali-soluble resin having a hydrogen-bonding capacity such as a novolac resin or a urethane resin, a layer including a water-insoluble and alkali-soluble resin and a compound having a dissolution suppressing action, and a layer including an ablation-possible compound.

In addition, by further adding an infrared absorbent to the upper layer, the heat generated from the upper layer can also be used in image formation. Preferable examples of the constitution of the upper layer including an infrared absorbent include a layer including an infrared absorbent, a water-insoluble and alkali-soluble resin, and a compound having a dissolution suppressing action, and a layer including an infrared absorbent, a water-insoluble and alkali-soluble resin, and an acid generator.

### - Water-insoluble and alkali-soluble resin -

It is preferable that the upper layer according to the present disclosure contains a water-insoluble and alkali-soluble resin. By containing the water-insoluble and alkali-soluble resin, an interaction is formed between the polar groups of the infrared absorbent and the water-insoluble and alkali-soluble resin, and a layer having a positive type photosensitivity is formed.

Typical water-insoluble and alkali-soluble resin will be described below in detail, and among these, a polyamide resin, an epoxy resin, a polyacetal resin, an acrylic resin, a methacrylic resin, a polystyrene-based resin, and a novolac-type phenolic resin are preferably exemplified.

The water-insoluble and alkali-soluble resin which can be used in the present disclosure is not particularly limited as long as it has a characteristic of being dissolved by contact with an alkaline developer, and a homopolymer containing an acidic group in the main chain and/or a side chain in the polymer, a copolymer thereof, or a mixture thereof is preferable.

Such a water-insoluble and alkali-soluble resin having an acidic group preferably has a functional group such as a phenolic hydroxyl group, a carboxy group, a sulfonic acid group, a phosphoric acid group, a sulfonamide group, or an active imide group. Therefore, such a resin can be suitably generated by copolymerizing a monomer mixture including one or more ethylenically unsaturated monomers having a functional group described above. As the ethylenically unsaturated monomer having a functional group described above, in addition to acrylic acid and methacrylic acid, a compound represented by the following formula and a mixture thereof can be preferably exemplified. Moreover, in the following formula, R⁴⁰ represents a hydrogen atom or a methyl group.

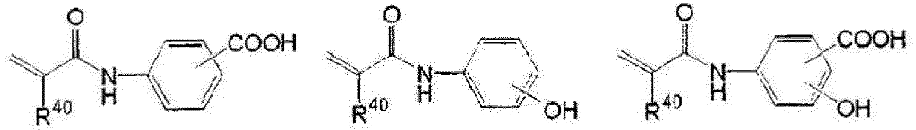

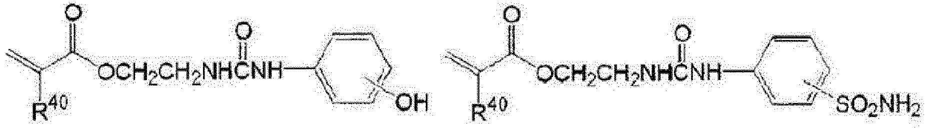

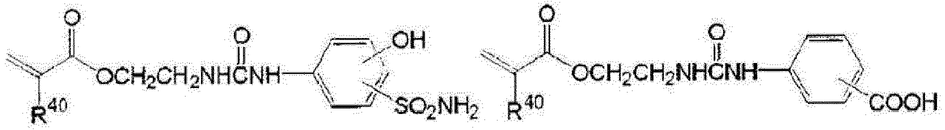

It is preferable that the water-insoluble and alkali-soluble resin which can be used in the present disclosure is a polymer compound obtained by copolymerizing another polymerizable monomer in addition to the above-mentioned polymerizable monomers. As the copolymerization ratio in this case, a monomer imparting alkali-solubility such as a monomer having a functional group such as a phenolic hydroxyl group, a carboxy group, a sulfonic acid group, a phosphoric acid group, a sulfonamide group, or an active imide group is preferably included in 10% by mole or greater, and more preferably included in 20% by mole or greater. In a case where the copolymerization component of the monomer imparting alkali-solubility is 10% by mole or greater, sufficient alkali-solubility is obtained, and developability is excellent.

Examples of other usable polymerizable monomers include compounds exemplified below.

Alkyl acrylates or alkyl methacrylates such as methyl acrylate, ethyl acrylate, propyl acrylate, benzyl acrylate, methyl methacrylate, ethyl methacrylate, cyclohexyl methacrylate, and benzyl methacrylate. Acrylic acid esters or methacrylic acid esters having an aliphatic hydroxyl group such as 2-hydroxyethyl acrylate and 2-hydroxyethyl methacrylate. Acrylamides or methacrylamides such as acrylamide, methacrylamide, N-methylacrylamide, N-ethylacrylamide, and N-phenylacrylamide. Vinyl esters such as vinyl acetate, vinyl chloroacetate, vinyl butyrate, and vinyl benzoate. Styrenes such as styrene, α-methylstyrene, methylstyrene, and chloromethylstyrene. Other nitrogen atom-containing monomers such as N-vinyl pyrrolidone, N-vinyl pyridine, acrylonitrile, and methacrylonitrile. Maleimides such as N-methylmaleimide, N-ethylmaleimide, N-propylmaleimide, N-butylmaleimide, N-phenylmaleimide, N-2-methylphenylmaleimide, N-2,6-diethylphenylmaleimide, N-2-chlorophenylmaleimide, N-cyclohexylmaleimide, N-laurylmaleimide, and N-hydroxyphenylmaleimide.

Among these other ethylenically unsaturated monomers, (meth)acrylic acid esters, (meth)acrylamides, maleimides, or (meth)acrylonitrile is suitably used.

In addition, as the alkali-soluble resin, a novolac resin exemplified as another alkali-soluble resin described as an optional component of the image recording layer according to the present disclosure may also be preferably exemplified.

In addition, the water-insoluble and alkali-soluble resin described above can also be used in the image recording layer according to the present disclosure.

Furthermore, in the upper layer according to the present disclosure, other resins can be used in combination within a range not impairing the effects of the positive type planographic printing plate precursor according to the embodiment of the present disclosure. Since the upper layer is required to express alkali-solubility, in particular, in a non-image area region, it is necessary to select a resin which does not impair this characteristic. From this viewpoint, as a resin usable in combination, a water-insoluble and alkali-soluble resin is exemplified. General water-insoluble and alkali-soluble resin will be described below in detail, and among these, a polyamide resin, an epoxy resin, a polyacetal resin, an acrylic resin, a methacrylic resin, a polystyrene-based resin, and a novolac-type phenolic resin are preferably exemplified.

In addition, the amount to be mixed is preferably 50% by mass or less with respect to the water-insoluble and alkali-soluble resin.

The water-insoluble and alkali-soluble resin preferably has a weight-average molecular weight of 2,000 or greater and a number average molecular weight of 500 or greater, and more preferably has a weight-average molecular weight of 5,000 to 300,000 and a number average molecular weight of 800 to 250,000. The dispersity (weight-average molecular weight/number average molecular weight) of the alkali-soluble resin is preferably 1.1 to 10.

The alkali-soluble resin in another recording layer according to the present disclosure may be used alone or in combination of two or more kinds thereof.

The content of the alkali-soluble resin in another recording layer according to the present disclosure is preferably in a range of 2.0% by mass to 99.5% by mass, more preferably in a range of 10.0% by mass to 99.0% by mass, and still more preferably in a range of 20.0% by mass to 90.0% by mass with respect to the total mass of another recording layer according to the present disclosure. In a case where the amount of the alkali-soluble resin to be added is 2.0% by mass or greater, the durability of the recording layer (photosensitive layer) is excellent. Further, in a case where the amount of the alkali-soluble resin to be added is 99.5% by mass or less, both the sensitivity and the durability are excellent.

### - Infrared absorbent -

The upper layer may contain an infrared absorbent.

The infrared absorbent is not particularly limited as long as it is a dye which generates heat by absorbing infrared light, and the infrared absorbent used in the image recording layer according to the present disclosure, described above, can also be used.

A particularly preferred dye is the cyanine coloring agent represented by Formula (a).

In a case where the upper layer contains an infrared absorbent, the sensitivity to infrared light becomes excellent.

The amount of the infrared absorbent to be added in the upper layer is preferably 0.01% by mass to 50% by mass, more preferably 0.1% by mass to 30% by mass, and particularly preferably 1.0% by mass to 10% by mass with respect to the total solid content in the upper layer. In a case where the amount of the infrared absorbent to be added is 0.01% by mass or greater, the sensitivity is improved, and in a case where the amount of the infrared absorbent to be added is 50% by mass or less, the uniformity of the layer is excellent and the durability of the layer is excellent.

### - Other components -

In addition, the upper layer of the planographic printing plate precursor having a two-layer structure may include an acid generator, an acid proliferation agent, a development accelerator, a surfactant, a print-out agent/colorant, a plasticizer, or a wax agent.

As these components, respective components used in the image recording layer according to the present disclosure, described above, can also be used, and the preferable aspects thereof are the same as described above.

### [Lower layer]

It is preferable that the lower layer of the planographic printing plate precursor having a two-layer structure according to the embodiment of the present disclosure is the image recording layer according to the present disclosure.

A printing plate with excellent image formability and printing durability can be obtained by using the image recording layer according to the present disclosure as the lower layer.

In a case where the image recording layer according to the present disclosure is used as the upper layer, it is preferable that the lower layer is also the image recording layer according to the present disclosure, but the lower layer may be another recording layer. The preferable aspects of the lower layer in this case are the same as the preferable aspects of the upper layer described above.

### <Support>

As a support used in the present disclosure, a support having a hydrophilic surface is preferable.

The support used in the positive type planographic printing plate precursor according to the embodiment of the present disclosure is not particularly limited as long as the support is a dimensionally stable plate-shaped material having required strength and durability, and examples thereof include the supports described in paragraphs 0166 to 0169 of WO2016/047392A.

In the description above, an aluminum support is preferable, and an aluminum support to which a hydrophilic treatment has been applied is particularly preferable.

### <Undercoat layer>

It is preferable that the positive type planographic printing plate precursor according to the embodiment of the present disclosure includes an undercoat layer between the support and the image recording layer.

In a case where the positive type planographic printing plate precursor according to the embodiment of the present disclosure is a planographic printing plate having a two-layer structure, it is preferable that the precursor includes the support and an undercoat layer between the support and the lower layer.

As the undercoat layer component, various organic compounds can be used, and preferable examples thereof include phosphonic acids having an amino group such as carboxymethyl cellulose or dextrin, an organic phosphonic acid, an organic phosphorus acid, an organic phosphinic acid, amino acids, and hydrochloride of an amine having a hydroxy group. In addition, these undercoat layer components may be used alone or in a mixture of two or more types thereof. Details of the compound used in the undercoat layer and the method of forming the undercoat layer are described in paragraphs 0171 and 0172 of JP2009-175195A, and those described here are also applied to the present disclosure.

The coating amount of the undercoat layer is preferably in a range of 2 mg/m² to 200 mg/m² and more preferably in a range of 5 mg/m² to 100 mg/m². In a case where the coating amount is in the above-described range, sufficient printing durability is obtained.

### <Back coat layer>

A back coat layer is provided on the rear surface of the support of the planographic printing plate precursor according to the embodiment of the present disclosure, as necessary. As the back coat layer, coating layers formed of an organic polymer compound described in JP1993-045885A (JP-H05-045885A) or a metal oxide obtained by hydrolyzing and polycondensing an organic or inorganic metal compound described in JP1994-035174A (JP-H06-035174A) are preferably used. Among these coating layers, alkoxy compounds of silicon such as Si(OCH₃)₄, Si(OC₂H₅)₄, Si(OC₃H₇)₄, and Si(OC₄H₉)₄ are easily available at low cost, and coating layers of metal oxides obtained from these have excellent developer resistance, and thus, these are particularly preferable.

### (Method of preparing planographic printing plate)

A method of preparing the planographic printing plate according to an embodiment of the present disclosure includes: an exposure step of subjecting the planographic printing plate precursor to image-wise light exposure; and a development step of subjecting the precursor to development using an alkali aqueous solution having a pH of 8.5 to 13.5, in this order.

According to the method of preparing the planographic printing plate according to the embodiment of the present disclosure, occurrence of development scum is suppressed and a planographic printing plate with excellent printing durability and chemical resistance is obtained.

Hereinafter, each step of the method of preparing a planographic printing plate according to the embodiment of the present disclosure will be described in detail.

### <Exposure step>

The method of preparing the planographic printing plate according to an embodiment of the present disclosure includes an exposure step of subjecting the positive type planographic printing plate precursor according to the embodiment of the present disclosure to image-wise light exposure. The detailed description is the same as the description in paragraphs 0173 to 0175 of WO2016/047392A.

### <Development step>

The method of preparing the planographic printing plate according to the embodiment of the present disclosure includes a development step of subjecting the precursor to development using an alkali aqueous solution with a pH of 8.5 to 13.5 (hereinafter, also referred to as a "developer").

### [Developer]

The developer used in the development step is an aqueous solution having a pH of 8.5 to 13.5 and more preferably an alkali aqueous solution having a pH of 12 to 13.5. The surfactant contributes to improvement of the processability.

Further, it is preferable that the developer contains a surfactant and more preferable that the developer contains at least an anionic surfactant or a nonionic surfactant. A surfactant contributes to improvement of processability.

As the surfactant used in the developer, any of an anionic surfactant, a nonionic surfactant, a cationic surfactant, and an amphoteric surfactant can be used, and as described above, an anionic surfactant or a nonionic surfactant is preferable.

As the anionic surfactant, the nonionic surfactant, the cationic surfactant, and the amphoteric surfactant used in the developer according to the method of preparing a planographic printing plate according to the embodiment of the present disclosure, the surfactants described in paragraphs 0128 to 0131 of JP2013-134341A can be used.

In addition, from the viewpoint of stable solubility or turbidity in water, a surfactant preferably has a hydrophile-lipophile balance (HLB) value of 6 or greater and more preferably has a HLB value of 8 or greater.

As the surfactant used in the developer, an anionic surfactant or a nonionic surfactant is preferable, and an anionic surfactant containing sulfonic acid or sulfonate or a nonionic surfactant having an aromatic ring and an ethylene oxide chain is particularly preferable.

The surfactant can be used alone or in combination.

The content of the surfactant in the developer is preferably in a range of 0.01% by mass to 10% by mass, and more preferably in a range of 0.01% by mass to 5% by mass.

In a case where as a buffer, carbonate ions and hydrogencarbonate ions are included to maintain the pH of the developer at 8.5 to 13.5, it is possible to suppress variations in pH even in a case where the developer is used for a long period of time, and it is possible to suppress developability deterioration and a development scum occurrence due to the variation in pH. To make carbonate ions and hydrogencarbonate ions present in the developer, carbonate and hydrogencarbonate may be added to the developer, or by adjusting the pH after carbonate or hydrogencarbonate is added, carbonate ions and hydrogencarbonate ions may be generated. Although carbonate and hydrogencarbonate are not particularly limited, an alkali metal salt is preferable. Examples of the alkali metal include lithium, sodium, and potassium, and sodium is particularly preferable. These may be used alone or in combination of two or more types thereof.

The total amount of carbonate and hydrogencarbonate is preferably in a range of 0.3% by mass to 20% by mass, more preferably in a range of 0.5% by mass to 10% by mass, and particularly preferably in a range of 1% by mass to 5% by mass, with respect to the total mass of the developer. In a case where the total amount is 0.3% by mass or greater, developability and processing capability are not reduced, and in a case where the total amount is 20% by mass or less, a precipitate or a crystal is less likely to be generated and at the time of the waste liquid treatment of the developer, gelation during neutralization is less likely to occur, and thus, trouble does not occur in the waste liquid treatment.

After the development step, a continuous or discontinuous drying step is preferably performed. Drying is performed by hot air, infrared rays, or far infrared rays.

As an automatic treatment machine suitably used for the method of preparing the planographic printing plate according to the embodiment of the present disclosure, a device having a developing unit and a drying unit is used, and a planographic printing plate is obtained by performing development and gumming on the positive type planographic printing plate precursor in a developer tank and drying the positive type planographic printing plate precursor in the drying unit.

In addition, for the purpose of improving printing durability or the like, it is also possible to heat the printing plate after developing in very strong conditions. The heating temperature is preferably in a range of 200°C to 500°C. In a case where the temperature is low, sufficient image strengthening effects are not obtained, and in a case where the temperature is too high, there is a possibility that problems such as deterioration of the support or thermal decomposition of the image area occur.

The planographic printing plate obtained in this manner is mounted on an offset printing machine, and can be suitably used in printing a large number of sheets.

### Examples

Hereinafter, the present disclosure will be described in detail based on examples. The materials, the used amounts, the proportions, the treatment contents, and the treatment procedures described in the following examples can be appropriately changed within the range not departing from the scope of the embodiment of the present disclosure. Therefore, the range of the embodiment of the present disclosure is not limited to the following specific examples. Moreover, "part" and "%" in the present examples respectively represent "part(s) by mass" and "% by mass" unless otherwise specified.

Hereinafter, compounds PU-1 to PU-35, compounds PA-1 to PA-12, and compounds PE-1 to PE-19 in examples each correspond to the compounds PU-1 to PU-35, the compounds PA-1 to PA-12, and the compounds PE-1 to PE-19 in the specific examples described above.

### (Examples)

### <Synthesis of compounds PU-1 to PU-35>

The compounds PU-1 to PU-35 were synthesized with reference to the method described in WO2016/133072A.

### <Synthesis of compounds PA-1 to PA-12>

The compounds PA-1 to PA-12 were synthesized with reference to the method described in EP1826001B.

### <Synthesis of compounds PE-1 to PE-12>

The compounds PE-1 to PE-12 were synthesized with reference to the method described in WO2014/106554A.

### <Preparation of support>

An aluminum alloy plate having a thickness of 0.3 mm of a material 1S was subjected to the following (A-a) to (A-k) treatments, thereby producing a support for a planographic printing plate. Moreover, during all treatment steps, a washing treatment with water was performed, and after the washing treatment with water, liquid cutting was performed using a nip roller.

### (A-a) Mechanical roughening treatment (brush grain method)

While supplying a suspension of pumice (specific gravity of 1.1 g/cm³) to the surface of an aluminum plate as a polishing slurry liquid, a mechanical roughening treatment was performed using rotating bundle bristle brushes.

The median diameter (µm) of a polishing material was 30 µm, the number of the brushes was four, and the rotation speed (rpm) of the brushes was set to 250 rpm. The material of the bundle bristle brushes was nylon-6,10, the diameter of the brush bristles was 0.3 mm, and the bristle length was 50 mm. The brushes were produced by implanting bristles densely into the holes in a stainless steel cylinder having φ300 mm. The distance between two support rollers (φ200 mm) of the lower portion of the bundle bristle brush was 300 mm. The bundle bristle brushes were pressed until the load of a driving motor for rotating the brushes became 10 kW plus with respect to the load before the bundle bristle brushes were pressed against the aluminum plate. The rotation direction of the brushes was the same as the moving direction of the aluminum plate.

### (A-b) Alkali etching treatment

The aluminum plate obtained above was subjected to an etching treatment by spraying a caustic soda aqueous solution in which the concentration of caustic soda was 26% by mass and the concentration of aluminum ions was 6.5% by mass using a spray tube at a temperature of 70°C. Thereafter, washing with water by spraying was performed. The amount of aluminum dissolved was 10 g/m².

### (A-c) Desmutting treatment in acidic aqueous solution

Next, a desmutting treatment was performed in a nitric acid aqueous solution. As the nitric acid aqueous solution used in the desmutting treatment, the waste liquid of nitric acid used in electrochemical roughening of the next step was used. The liquid temperature was 35°C. The desmutting treatment was performed for 3 seconds by spraying the desmutting liquid using a spray.

### (A-d) Electrochemical roughening treatment

An electrochemical roughening treatment was continuously performed using an AC voltage of nitric acid electrolysis 60 Hz. As the electrolyte at this time, an electrolyte which had been adjusted to have a concentration of aluminum ions of 4.5 g/L by adding aluminum nitrate to a nitric acid aqueous solution having a concentration of 10.4 g/L at a temperature of 35°C was used. Using a trapezoidal rectangular waveform AC having a time tp until the current value reached a peak from zero of 0.8 msec and the duty ratio of 1:1 as the AC power source waveform, the electrochemical roughening treatment was performed using a carbon electrode as a counter electrode. As an auxiliary anode, ferrite was used. The current density was 30 A/dm² as the peak current value, and 5% of the current from the power source was separately flowed to the auxiliary anode. The electric quantity (C/dm²) was 185 C/dm² as the sum total of electric quantity at the time of anodization of the aluminum plate. Thereafter, washing with water by spraying was performed.

### (A-e) Alkali etching treatment

The aluminum plate obtained above was subjected to an etching treatment by spraying a caustic soda aqueous solution in which the concentration of caustic soda was 5% by mass and the concentration of aluminum ions was 0.5% by mass using a spray tube at a temperature of 50°C. Thereafter, washing with water by spraying was performed. The amount of aluminum dissolved was 0.5 g/m².

### (A-f) Desmutting treatment in acidic aqueous solution

Next, a desmutting treatment was performed in a sulfuric acid aqueous solution. As the sulfuric acid aqueous solution used in the desmutting treatment, a solution in which the concentration of sulfuric acid was 170 g/L and the concentration of aluminum ions was 5 g/L was used. The liquid temperature was 30°C. The desmutting treatment was performed for 3 seconds by spraying the desmutting liquid using a spray.

### (A-g) Electrochemical roughening treatment

An electrochemical roughening treatment was continuously performed using an AC voltage of hydrochloric acid electrolysis 60 Hz. As the electrolyte, an electrolyte which had been adjusted to have a concentration of aluminum ions of 4.5 g/L by adding aluminum chloride to a hydrochloric acid aqueous solution having a concentration of 6.2 g/L at a liquid temperature of 35°C was used. Using a trapezoidal rectangular waveform AC having a time tp until the current value reached a peak from zero of 0.8 msec and the duty ratio of 1:1, the electrochemical roughening treatment was performed using a carbon electrode as a counter electrode. As an auxiliary anode, ferrite was used.

The current density was 25 A/dm² as the peak current value, and the electric quantity (C/dm²) in the hydrochloric acid electrolysis was 63 C/dm² as the sum total of electric quantity at the time of anodization of the aluminum plate. Thereafter, washing with water by spraying was performed.

### (A-h) Alkali etching treatment

The aluminum plate obtained above was subjected to an etching treatment by spraying a caustic soda aqueous solution in which the concentration of caustic soda was 5% by mass and the concentration of aluminum ions was 0.5% by mass using a spray tube at a temperature of 50°C. Thereafter, washing with water by spraying was performed. The amount of aluminum dissolved was 0.1 g/m².

### (A-i) Desmutting treatment in acidic aqueous solution

Next, a desmutting treatment was performed in a sulfuric acid aqueous solution. Specifically, the desmutting treatment was performed at a liquid temperature of 35°C for 4 seconds using the waste liquid (aluminum ions having a concentration of 5 g/L were dissolved in a sulfuric acid aqueous solution having a concentration of 170 g/L) generated in the anodization treatment step. The desmutting treatment was performed for 3 seconds by spraying the desmutting liquid using a spray.

### (A-j) Anodization treatment

An anodization treatment was performed using an anodization apparatus (the length of each of a first electrolytic portion and a second electrolytic portion was 6 m, the length of each of a first feeding portion and a second feeding portion was 3 m, and the length of each of a first feeding electrode and a second feeding electrode was 2.4 m) of a two-stage feeding electrolytic treatment method. As the electrolyte supplied to the first electrolytic portion and the second electrolytic portion, sulfuric acid was used. All electrolytes have a concentration of sulfuric acid of 50 g/L (including 0.5% by mass of aluminum ions) and were at a temperature of 20°C. Thereafter, washing with water by spraying was performed.

### (A-k) Silicate treatment

To ensure hydrophilicity of the non-image area, a silicate treatment was performed by dipping at 50°C for 7 seconds using 2.5% by mass No. 3 sodium silicate aqueous solution. The amount of Si attached was 10 mg/m². Thereafter, washing with water by spraying was performed.

### <Formation of undercoat layer>

The support prepared in the above-described manner was coated with an undercoat layer coating solution 1 described below, and the coating solution was dried at 80°C for 15 seconds to provide an undercoat layer, thereby preparing a support. The coating amount after drying was 15 mg/m².

### [Undercoat layer coating solution 1]

- Following copolymer having weight-average molecular weight of 28000: 0.3 parts
- Methanol: 100 parts
- Water: 1 part

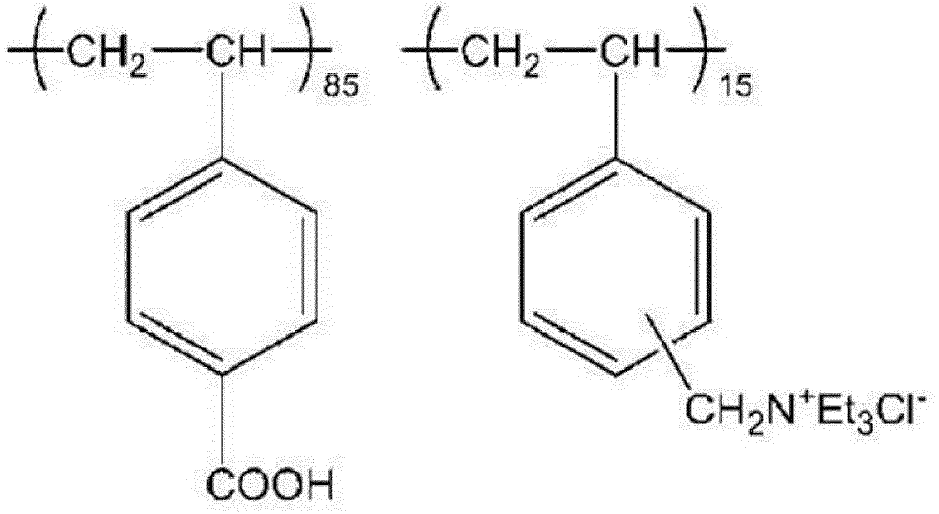

In the formulae, Et represents an ethyl group, and the subscripts of parentheses each indicate the content ratio (molar ratio).

### <Formation of recording layer>

After the obtained support was coated with a coating solution composition (I) for forming a lower layer having the following composition using a wire bar, the resulting product was dried in a drying oven at 150°C for 40 seconds such that the coating amount thereof was set to 1.0 g/m², and thus a lower layer was provided. After the lower layer was provided, the lower layer was coated with a coating solution composition (II) for forming an upper layer having the following composition using a wire bar, whereby an upper layer was provided. After the coating, the resulting product was dried at 150°C for 40 seconds, whereby a planographic printing plate precursor in which the coating amount of the lower layer and the upper layer was 1.2 g/m² was obtained.

### [Coating solution composition (I) for forming lower layer]

- Polymer compound 1 listed in Table 4: amounts listed in Table 4
- Polymer compound 2-1 or 2-2 listed in Table 4: amounts listed in Table 4
- m,p-Cresol novolac (m/p ratio = 6/4, weight-average molecular weight of 6,000): 0.6 parts
- Infrared absorbent (IR coloring agent (1): following structure): 0.2 parts
- 4,4'-Bishydroxyphenyl sulfone: 0.3 parts
- Tetrahydrophthalic acid: 0.4 parts
- p-Toluenesulfonic acid: 0.02 parts
- 3-Methoxy-4-diazodiphenylamine hexafluorophosphate: 0.06 parts
- Product obtained by replacing a counter ion of ethyl violet with 6-hydroxynaphthalenesulfonic acid: 0.15 parts
- Fluorine-based surfactant (MEGAFACE F-780, manufactured by DIC Corporation): 0.07 parts
- Methyl ethyl ketone: 30 parts
- 1-Methoxy-2-butyrolactone: 15 parts
- γ-Butyrolactone: 15 parts

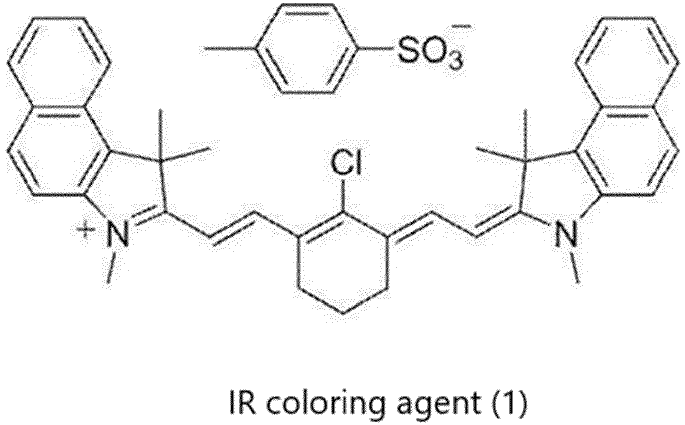

### [Coating solution composition (II) for forming upper layer]

- Novolac resin (m-cresol/p-cresol/phenol = 3/2/5, Mw of 8,000): 0.68 parts
- Infrared absorbent (IR coloring agent (1): above structure): 0.045 parts
- Fluorine-based surfactant (MEGAFACE F-780, manufactured by DIC Corporation): 0.03 parts
- Methyl ethyl ketone: 15.0 parts
- 1-Methoxy-2-propanol: 30.0 parts
- 5-Benzoyl-4-hydroxy-2-methoxybenzenesulfonate of 1-(4-methylbenzyl)-1-phenylpiperidinium: 0.01 parts

The following evaluations were performed using the obtained planographic printing plate precursors, and the results are listed in the following Table 4.

### <Evaluation of planographic printing plate precursor>

### [Evaluation of solubility resistance of image area and non-image area development time]

Drawing of a test pattern in an image was performed on each positive type planographic printing plate precursor of each example and each comparative example using a Trendsetter VX (manufactured by Creo Company) at a beam intensity of 9 W and a drum rotation speed of 150 rpm.

Thereafter, the resulting product was immersed in a developing bath charged with a developer XP-D (which was made to have a conductivity of 43 mS/cm by dilution) (manufactured by Fujifilm Corporation), and the time taken until the dissolution of the image area was started at a development temperature of 30°C and the time required for developing the non-image area were measured.

The time taken until the dissolution of the image area was started was set as the time taken until the measured value of the optical density (OD value) in the image area was decreased by 0.05 from the measured value of the optical density in the image area before the development treatment. Further, the immersion time at which a difference between the measured value of the optical density in the non-image area and the measured value of the optical density of the aluminum support reached 0.02 or less was set as the non-image area development time. In both cases, the optical density was measured using a spectrophotometer SpectroEye (manufactured by GretagMacbeth Company).

As the time until the dissolution of the image area is started is longer, the resistance to an alkali aqueous solution is excellent. Further, as the non-image area development time is shorter, the solubility of the non-image area in an alkali aqueous solution is excellent and an alkali aqueous solution developability (highlight reproducibility) is good. Accordingly, it is evaluated that the positive type planographic printing plate precursor has excellent developability in a case where the image area dissolution starting time is long, the non-image area development time is short, and the difference between the image area dissolution starting time and the non-image area development time is large. The results are listed in Table 4.

### [Evaluation of printing durability]

Drawing of a test pattern in an image was performed on each positive type planographic printing plate precursor of each example and each comparative example using a Trendsetter (manufactured by Creo company) at a beam intensity of 9 W and a drum rotation speed of 150 rpm. Thereafter, using PS PROCESSOR LP940H (manufactured by Fujifilm Corporation) charged with a developer XP-D (which was made to have a conductivity of 43 mS/cm by dilution) (manufactured by Fujifilm Corporation), development was performed at a developing temperature of 30°C for the development time which was the non-image area development time listed in Table 4. This was continuously printed using a printing machine LITHRONE (manufactured by KOMORI Corporation). As the ink, a tokunen black ink (manufactured by TOYO INK CO., LTD.) containing calcium carbonate was used as a model of a low-grade material. At this time, by visually measuring how many sheets could be printed while maintaining a sufficient ink density, the printing durability was evaluated. It was evaluated that the printing durability was excellent as the number of sheets was larger. The results are listed in Table 4.

### [Evaluation of chemical resistance]

Exposure, development, and printing were performed on each positive type planographic printing plate precursor of each example and each comparative example in the same manner as in the evaluation of the printing durability. In this time, every time 5,000 sheets were printed, a step of wiping the plate surface with a cleaner (manufactured by Fujifilm Corporation, multi cleaner) was performed, and the chemical resistance was evaluated. The printing durability at this time was evaluated as 1 in a case where the number of printed sheets was 95% to 100% of the number of printing endurable sheets described above, evaluated as 2 in a case where the number of printed sheets was 80% or greater and less than 95%, evaluated as 3 in a case where the number of printed sheets was 60% or greater and less than 80%, and evaluated as 4 in a case where the number of printed sheets was less than 60%. Even in a case where the step of wiping the plate surface with a cleaner was performed, as the change in the printing durability index was smaller, the chemical resistance was evaluated to be excellent. The results are listed in Table 4.

### [Evaluation of development scum]

Drawing of a test pattern in an image was performed on each positive type planographic printing plate precursor using a Trendsetter VX (trade name, manufactured by Creo Company) at a beam intensity of 6 W and a drum rotation speed of 150 rpm.

Thereafter, the resulting product was immersed in a developing bath charged with a developer XP-D (which was made to have a conductivity of 43 mS/cm by dilution) (manufactured by Fujifilm Corporation) for the time required for the development of the non-image area listed in Table 4 at a development temperature of 30°C.

After the development treatment, the amount of scum attached to the surface of the printing plate was evaluated. A case where less than 5 pieces of scums were found in an area of 25 cm² was evaluated as 1, a case where less than 10 pieces of scums were found in an area of 25 cm² was evaluated as 2, a case where less than 20 pieces of scums were found in an area of 25 cm² was evaluated as 3, and a case where 20 or more pieces of scums were found in an area of 25 cm² was evaluated as 4. As the number of pieces of development scums was decreased, it was evaluated that the development scum was satisfactorily suppressed. In practical use, it is preferable that the development scum was evaluated as 1 or 2.

**[Table 4]**

| | Polymer compound 1 | Amount of polymer compound 1 to be added | Polymer compound 2-1 or 2-2 | Amount of polymer compound 2-1 or 2-2 to be added | Evaluation results | | | | |
|---|---|---|---|---|---|---|---|---|---|
| | | | | | Non-image area development time (sec) | Image area dissolution starting time (sec) | Printing durability Number of printed sheets (10000 sheets) | Chemical resistance | Develop ment scum |
| Example 1 | PU-1 | 2.0 parts | PA-1 | 1.5 parts | 10 | 28 | 12 | 1 | 2 |
| Example2 | PU-1 | 1.5 parts | PA-1 | 2.0 parts | 10 | 28 | 13 | 1 | 1 |
| Example3 | PU-1 | 1.0 parts | PA-1 | 2.5 parts | 10 | 28 | 13 | 1 | 1 |
| Example4 | PU-1 | 2.7 parts | PA-1 | 0.8 parts | 10 | 28 | 13 | 1 | 2 |
| Example5 | PU-1 | 0.9 parts | PA-1 | 2.6 parts | 11 | 29 | 11 | 2 | 1 |
| Example6 | PU-1 | 2.5 parts | PA-8 | 1.0 parts | 9 | 28 | 14 | 2 | 1 |
| Example7 | PU-1 | 2.5 parts | PA-9 | 1.0 parts | 9 | 28 | 12 | 1 | 1 |
| Example8 | PU-1 | 2.5 parts | PA-11 | 1.0 parts | 9 | 28 | 11 | 1 | 1 |
| Example9 | PU-1 | 2.5 parts | PA-12 | 1.0 parts | 9 | 28 | 13 | 1 | 1 |
| Example 10 | PU-4 | 2.5 parts | PA-1 | 1.0 parts | 9 | 27 | 12 | 1 | 2 |
| Example 11 | PU-5 | 2.5 parts | PA-1 | 1.0 parts | 9 | 28 | 13 | 1 | 1 |
| Example12 | PU-7 | 2.5 parts | PA-1 | 1.0 parts | 10 | 27 | 13 | 1 | 2 |
| Example13 | PU-19 | 2.5 parts | PA-1 | 1.0 parts | 9 | 28 | 14 | 1 | 1 |
| Examplel4 | PU-31 | 2.5 parts | PA-1 | 1.0 parts | 9 | 28 | 12 | 1 | 1 |
| Example15 | PU-34 | 2.5 parts | PA-1 | 1.0 parts | 10 | 27 | 12 | 1 | 2 |
| Example16 | PU-35 | 2.5 parts | PA-1 | 1.0 parts | 9 | 28 | 13 | 1 | 1 |
| Example17 | PU-1 | 2.0 parts | PE-1 | 1.0 parts | 10 | 30 | 15 | 1 | 2 |
| Example18 | PU-1 | 1.5 parts | PE-1 | 1.0 parts | 11 | 30 | 14 | 2 | 1 |
| Example19 | PU-1 | 1.0 parts | PE-1 | 1.0 parts | 11 | 30 | 15 | 1 | 1 |
| Example20 | PU-1 | 2.5 parts | PE-6 | 1.0 parts | 12 | 29 | 15 | 1 | 1 |
| Example21 | PU-1 | 2.5 parts | PE-12 | 1.0 parts | 11 | 30 | 15 | 1 | 1 |
| Example22 | PU-1 | 2.5 parts | PE-14 | 1.0 parts | 12 | 30 | 15 | 1 | 1 |
| Example23 | PU-1 | 2.5 parts | PE-15 | 1.0 parts | 13 | 31 | 14 | 1 | 1 |
| Example24 | PU-1 | 2.5 parts | PE-16 | 1.0 parts | 12 | 31 | 15 | 1 | 1 |
| Example25 | PU-1 | 2.5 parts | PE-17 | 1.0 parts | 12 | 31 | 14 | 1 | 1 |
| Example26 | PU-1 | 2.5 parts | PE-18 | 1.0 parts | 12 | 31 | 14 | 1 | 1 |
| Example27 | PU-1 | 2.5 parts | PE-19 | 1.0 parts | 12 | 30 | 14 | 2 | 1 |
| Example28 | PU-4 | 2.5 parts | PE-1 | 1.0 parts | 12 | 30 | 14 | 1 | 2 |
| Example29 | PU-5 | 2.5 parts | PE-1 | 1.0 parts | 11 | 30 | 14 | 1 | 1 |
| Example30 | PU-7 | 2.5 parts | PE-1 | 1.0 parts | 11 | 31 | 14 | 1 | 1 |
| Example31 | PU-19 | 2.5 parts | PE-1 | 1.0 parts | 11 | 32 | 16 | 1 | 1 |
| Example32 | PU-31 | 2.5 parts | PE-1 | 1.0 parts | 11 | 30 | 14 | 1 | 1 |
| Example33 | PU-34 | 2.5 parts | PE-1 | 1.0 parts | 11 | 30 | 14 | 2 | 1 |
| Example34 | PU-35 | 2.5 parts | PE-1 | 1.0 parts | 12 | 31 | 15 | 1 | 1 |
| Comparative Example1 | CP-1 | 2.5 parts | PA-1 | 1.0 parts | 100 | 150 | 7 | 2 | 3 |
| Comparative Example2 | CP-1 | 2.5 parts | PE-1 | 1.0 parts | 100 | 150 | 8 | 2 | 3 |
| Comparative Example3 | CP-2 | 2.5 parts | PA-1 | 1.0 parts | 25 | 30 | 6 | 4 | 2 |
| Comparative Example4 | CP-3 | 2.5 parts | PA-1 | 1.0 parts | 10 | 40 | 3 | 1 | 1 |
| Comparative Example5 | - | - | PA-1 | 1.0 parts | 22 | 40 | 7 | 3 | 2 |
| Comparative Example6 | - | - | PE-1 | 1.0 parts | 25 | 45 | 7 | 2 | 2 |

Further, the structures of CP-1, CP-2, and CP-3 used in Comparative Examples 1 to 4 are as shown below. In the structures, Me represents a methyl group, and each numerical value on the lower right side of parentheses indicates the molar ratio. CP-1, CP-2, and CP-3 were synthesized with reference to the method described in WO2016/133072A.

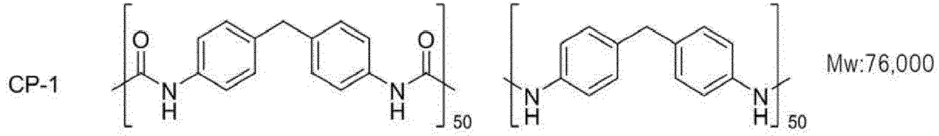

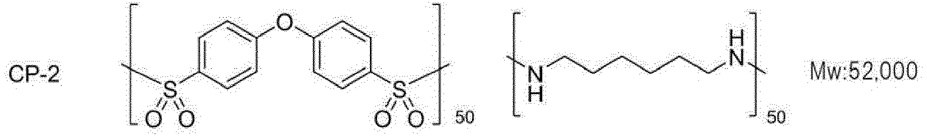

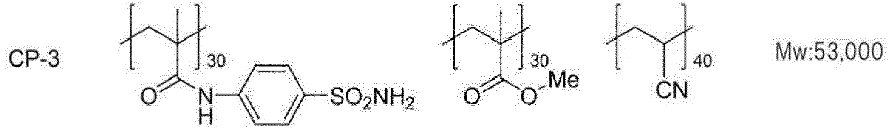

Based on the results listed in Table 4, it was found that the positive type planographic printing plate precursor according to the embodiment of the present disclosure has excellent printing durability, developability, and chemical resistance, and occurrence of development scum is satisfactorily suppressed.

## Claims

1. A positive type planographic printing plate precursor, comprising:
a support; and
an image recording layer on the support,
the image recording layer comprising: a polymer compound 1 having a linking group represented by the following Formula A-1 in a main chain thereof; a polymer compound 2-1 comprising at least one selected from the group consisting of a constitutional unit represented by the following Formula S-1 and a constitutional unit represented by the following Formula S-2, or a polymer compound 2-2 comprising a constitutional unit represented by the following Formula EV-1 and a constitutional unit represented by the following Formula EV-2; and an infrared absorbent, 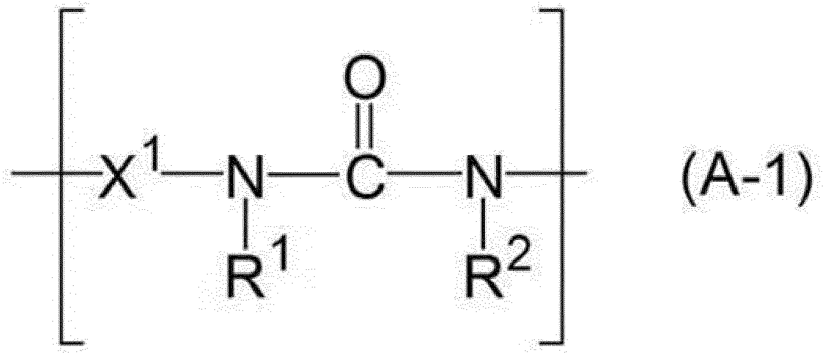
wherein, in Formula A-1, each of R¹ and R² independently represents a hydrogen atom or a monovalent organic group; and X¹ represents a linking group represented by any of the following Formulae A-2 to A-6: 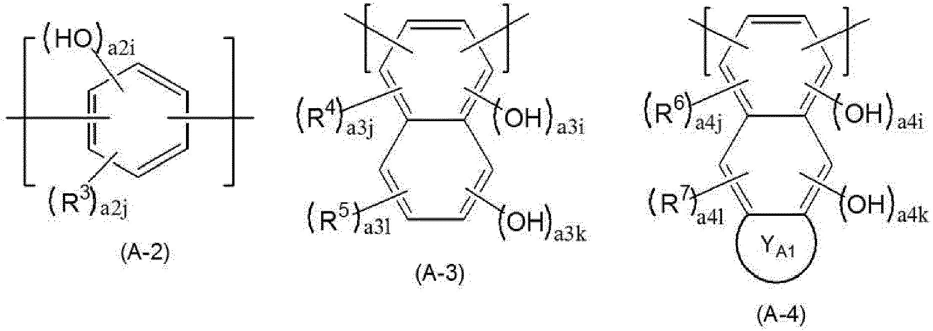 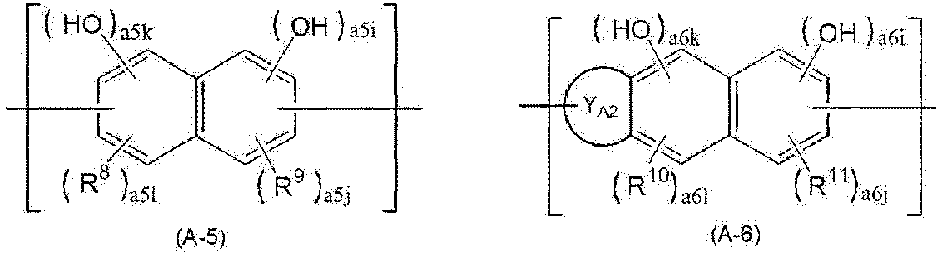
wherein, in Formulae A-2 to A-6, R³ represents a halogen atom or a monovalent organic group; a2i represents an integer of 1 to 4; a2j represents an integer of 0 to 3; a2i + a2j is 1 to 4; each of R⁴ and R⁵ independently represents a halogen atom or a monovalent organic group; each of a3i and a3j independently represents an integer of 0 to 2; each of a3k and a31 independently represents an integer of 0 to 4; a3i + a3k is 1 to 6; a3j + a31 is 0 to 6 - (a3i + a3k); each of R⁶ and R⁷ independently represents a halogen atom or a monovalent organic group; each of a4i and a4k independently represents an integer of 0 to 2; a4i + a4k is 1 to 4; each of a4j and a41 independently represents an integer of 0 to 2; a4j + a41 is 0 to 4 - (a4i + a4k); Y_{A1} represents an aromatic hydrocarbon ring or an aliphatic hydrocarbon ring; each of R⁸ and R⁹ independently represents a halogen atom or a monovalent organic group; each of a5i and a5k independently represents an integer of 0 to 3; a5i + a5k is 1 to 6; each of a5j and a51 independently represents an integer of 0 to 3; a5j + a51 is 0 to 6 - (a5i + a5k); each of R¹⁰ and R¹¹ independently represents a halogen atom or a monovalent organic group; a6k represents an integer of 0 to 2; a6i represents an integer of 0 to 3; a6i + a6k is 1 to 5; a61 represents an integer of 0 to 2; a6j represents an integer of 0 to 3; a61 + a6j is 0 to 5 - (a6i +a6k); and Y_{A2} represents an aromatic hydrocarbon ring or an aliphatic hydrocarbon ring: 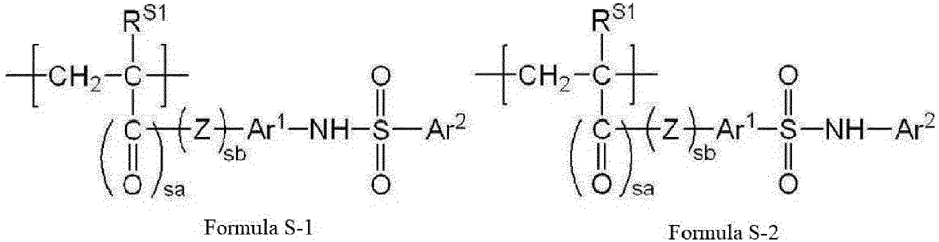
wherein, in Formulae S-1 and S-2, R^{S1} represents a hydrogen atom or an alkyl group; Z represents -O- or -N(R^{S2}), wherein R^{S2} represents a hydrogen atom, an alkyl group, an alkenyl group, or an alkynyl group; each of Ar¹ and Ar² independently represents an aromatic group, and at least one of Ar¹ or Ar² represents a heteroaromatic group; and each of sa and sb independently represents 0 or 1; and 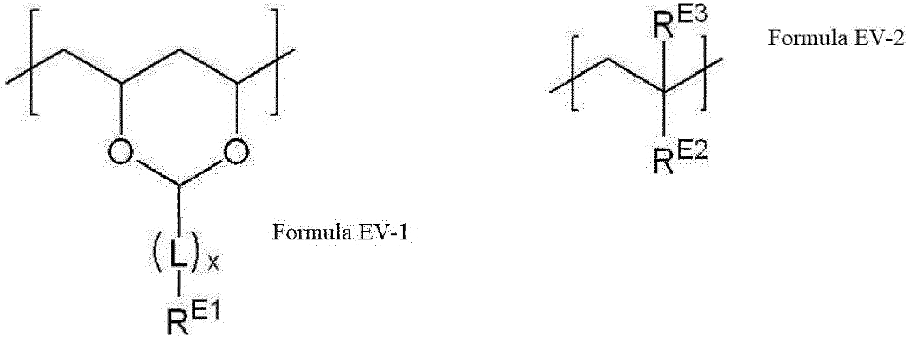
wherein, in Formulae EV-1 and EV-2, L represents a divalent linking group; x represents 0 or 1; R^{E1} represents an aromatic ring which contains at least one hydroxy group or a heteroaromatic ring which contains at least one hydroxy group; and each of R^{E2} and R^{E3} independently represents a hydrogen atom, a halogen atom, a linear, branched, or cyclic alkyl group which may have a substituent, a linear, branched, or cyclic alkenyl group which may have a substituent, an aromatic ring which may have a substituent, or a heteroaromatic ring which may have a substituent.

2. The positive type planographic printing plate precursor according to claim 1, wherein each of R¹ and R² independently represents a hydrogen atom, an alkyl group, or an aryl group.

3. The positive type planographic printing plate precursor according to claim 1 or 2, wherein:
R³ represents a halogen atom, an alkyl group, or an aryl group;
each of R⁴ and R⁵ independently represents a halogen atom, an alkyl group, or an aryl group;
each of R⁶ and R⁷ independently represents a halogen atom, an alkyl group, or an aryl group;
each of R⁸ and R⁹ independently represents a halogen atom, an alkyl group, or an aryl group; and
each of R¹⁰ and R¹¹ independently represents a halogen atom, an alkyl group, or an aryl group.

4. The positive type planographic printing plate precursor according to any one of claims 1 to 3,
wherein the polymer compound 1 comprises a linking group represented by the following Formula A-7 in a main chain thereof: 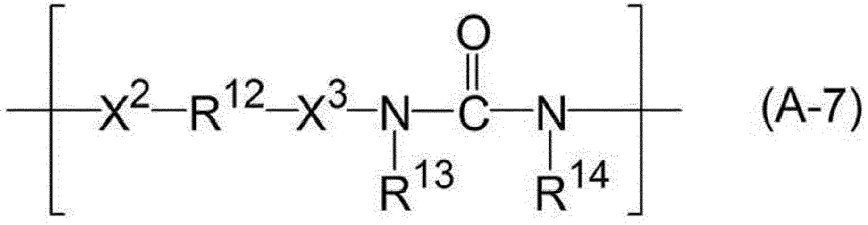 wherein, in Formula A-7, R¹² represents a single bond or a divalent linking group; each of R¹³ and R¹⁴ independently represents a hydrogen atom or a monovalent organic group; and each of X² and X³ independently represents a linking group represented by any one of Formulae A-2 to A-6.

5. The positive type planographic printing plate precursor according to claim 4, wherein:
R¹² represents a single bond, an alkylene group having 6 or less carbon atoms, or a sulfonyl group; and
each of R¹³ and R¹⁴ independently represents an alkyl group or aryl group.

6. The positive type planographic printing plate precursor according to claim 4 or 5,
wherein the linking group represented by Formula A-7 is a linking group represented by the following Formula A-8: 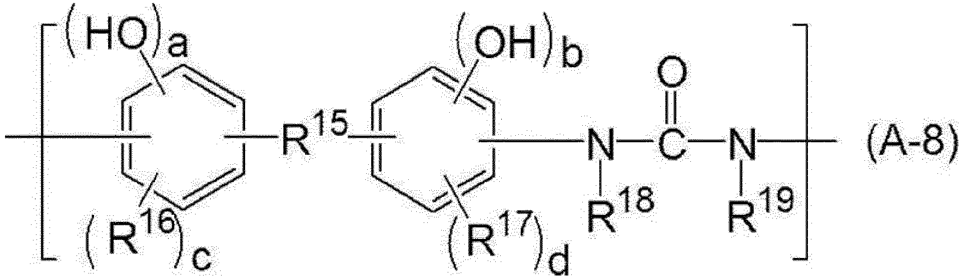 wherein, in Formula A-8, R¹⁵ represents a single bond or a divalent linking group; each of R¹⁶ and R¹⁷ independently represents a halogen atom or a monovalent organic group; each of R¹⁸ and R¹⁹ independently represents a hydrogen atom or a monovalent organic group; each of a, b, c, and d independently represents an integer of 0 to 4; a + b is 1 to 8; and c + d is 0 to 8 - (a + b).

7. The positive type planographic printing plate precursor according to claim 6, wherein:
R¹⁵ represents a single bond, an alkylene group having 6 or less carbon atoms, or a sulfonyl group; and
each of R¹⁶ and R¹⁷ independently represents a halogen atom, an alkyl group, or an aryl group; and
each of R¹⁸ and R¹⁹ independently represents an alkyl group or an aryl group.

8. The positive type planographic printing plate precursor according to any one of claims 1 to 7, comprising a recording layer having a lower layer and an upper layer in this order on the support,
wherein at least one of the lower layer or the upper layer is the image recording layer.

9. The positive type planographic printing plate precursor according to any one of claims 1 to 8, further comprising an undercoat layer between the support and the image recording layer.

10. A method of preparing a planographic printing plate, comprising:
subjecting the positive type planographic printing plate precursor according to any one of claims 1 to 9 to image-wise light exposure; and
subjecting the exposed positive type planographic printing plate precursor to development using an alkali aqueous solution having a pH of 8.5 to 13.5.

## Patentansprüche

1. Flachdruckplattenvorläufer vom Positivtyp, umfassend:
einen Träger; und
eine Bildaufzeichnungsschicht auf dem Träger,
wobei die Bildaufzeichnungsschicht umfasst: eine Polymerverbindung 1 mit einer durch die folgende Formel A-1 dargestellten Verknüpfungsgruppe in einer Hauptkette hiervon; eine Polymerverbindung 2-1, umfassend zumindest eines, ausgewählt aus der Gruppe bestehend aus einer durch die folgende Formel S-1 dargestellten Aufbaueinheit und einer durch die folgende Formel S-2 dargestellten Aufbaueinheit, oder eine Polymerverbindung 2-2, umfassend eine durch die folgende Formel EV-1 dargestellte Aufbaueinheit und eine durch die folgende Formel EV-2 dargestellte Aufbaueinheit; und einen Infrarotabsorber, 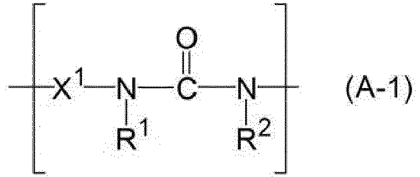
worin in der Formel A-1 jedes von R¹ und R² unabhängig ein Wasserstoffatom oder eine monovalente organische Gruppe darstellt; und X¹ eine durch irgendeine der folgenden Formeln A-2 bis A-6 dargestellte Verknüpfungsgruppe darstellt: 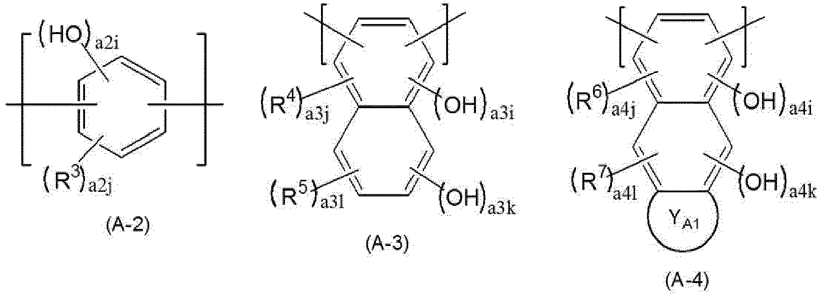 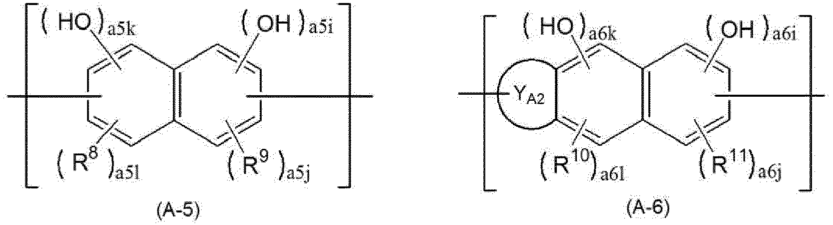
worin in den Formeln A-2 bis A-6 R³ ein Halogenatom oder eine monovalente organische Gruppe darstellt; a2i eine ganze Zahl von 1 bis 4 darstellt; a2j eine ganze Zahl von 0 bis 3 darstellt; a2i + a2j 1 bis 4 ist; jedes von R⁴ und R⁵ unabhängig ein Halogenatom oder eine monovalente organische Gruppe darstellt; jedes von a3i und a3j eine ganze Zahl von 0 bis 2 darstellt; jedes von a3k und a3l unabhängig eine ganze Zahl von 0 bis 4 darstellt; a3i + a3k 1 bis 6 ist; a3j + a3l 0 bis 6 - (a3i + a3k) ist; jedes von R⁶ und R⁷ unabhängig ein Halogenatom oder eine monovalente organische Gruppe darstellt; jedes von a4i und a4k unabhängig eine ganze Zahl von 0 bis 2 darstellt; a4i + a4k 1 bis 4 ist; jedes von a4j und a41 unabhängig eine ganze Zahl von 0 bis 2 darstellt; a4j + a41 0 bis 4 - (a4i + a4k) ist; Y_{A1} einen aromatischen Kohlenwasserstoffring oder einen aliphatischen Kohlenwasserstoffring darstellt; jedes von R⁸ und R⁹ unabhängig ein Halogenatom oder eine monovalente organische Gruppe darstellt; jedes von a5i und a5k unabhängig eine ganze Zahl von 0 bis 3 darstellt; a5i + a5k 1 bis 6 ist; jedes von a5j und a51 unabhängig eine ganze Zahl von 0 bis 3 darstellt; a5j + a51 0 bis 6 - (a5i + a5k) ist; jedes von R¹⁰ und R¹¹ unabhängig ein Halogenatom oder eine monovalente organische Gruppe darstellt; a6k eine ganze Zahl von 0 bis 2 darstellt; a6i eine ganze Zahl von 0 bis 3 darstellt; a6i + a6k 1 bis 5 ist; a6l ganze Zahl von 0 bis 2 darstellt; a6j eine ganze Zahl von 0 bis 3 darstellt; a6l + a6j 0 bis 5 - (a6i + a6k) ist; und Y_{A2} einen aromatischen Kohlenwasserstoffring oder einen aliphatischen Kohlenwasserstoffring darstellt: 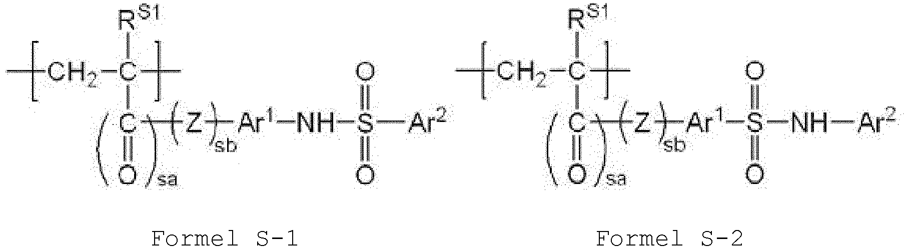
worin in den Formeln S-1 und S-2 R^{S1} ein Wasserstoffatom oder eine Alkylgruppe darstellt; Z -O- oder -N(R^{S2}) darstellt, worin R^{S2} ein Wasserstoffatom, eine Alkylgruppe, eine Alkenylgruppe oder eine Alkinylgruppe darstellt, jedes von Ar¹ und Ar² unabhängig eine aromatische Gruppe darstellt und mindestens eines von Ar¹ oder Ar² eine heteroaromatische Gruppe darstellt; und jedes von sa und sb unabhängig 0 oder 1 darstellt; und 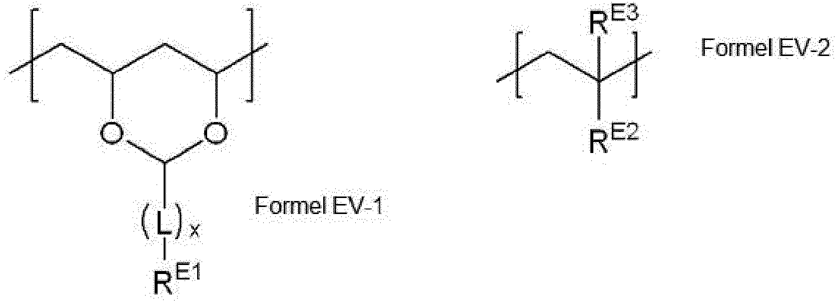
worin in Formeln EV-1 und EV-2 L eine divalente Verknüpfungsgruppe darstellt; x 0 oder 1 darstellt; R^{E1} einen aromatischen Ring, der mindestens eine Hydroxygruppe enthält, oder einen heteroaromatischen Ring, der mindestens eine Hydroxygruppe enthält, darstellt; und jedes von R^{E2} und R^{E3} unabhängig ein Wasserstoffatom, ein Halogenatom, eine lineare, verzweigte oder cyclische Alkylgruppe, die einen Substituenten aufweisen kann, eine lineare, verzweigte oder cyclische Alkenylgruppe, die einen Substituenten aufweisen kann, einen aromatischen Ring, der einen Substituenten aufweisen kann, oder einen heteroaromatischen Ring, der einen Substituenten aufweisen kann, darstellt.

2. Flachdruckplattenvorläufer vom Positivtyp gemäß Anspruch 1, worin jedes von R¹ und R² unabhängig ein Wasserstoffatom, eine Alkylgruppe oder eine Arylgruppe darstellt.

3. Flachdruckplattenvorläufer vom Positivtyp gemäß Anspruch 1 oder 2, worin:
R³ ein Halogenatom, eine Alkylgruppe oder eine Arylgruppe darstellt;
jedes von R⁴ und R⁵ unabhängig ein Halogenatom, eine Alkylgruppe oder eine Arylgruppe darstellt;
jedes von R⁶ und R⁷ unabhängig ein Halogenatom, eine Alkylgruppe oder eine Arylgruppe darstellt;
jedes von R⁸ und R⁹ unabhängig ein Halogenatom, eine Alkylgruppe oder eine Arylgruppe darstellt;
jedes von R¹⁰ und R¹¹ unabhängig ein Halogenatom, eine Alkylgruppe oder eine Arylgruppe darstellt.

4. Flachdruckplattenvorläufer vom Positivtyp gemäß irgendeinem der Ansprüche 1 bis 3,
worin die Polymerverbindung 1 eine durch die folgende Formel A-7 dargestellte Verknüpfungsgruppe in einer Hauptkette hiervon umfasst: 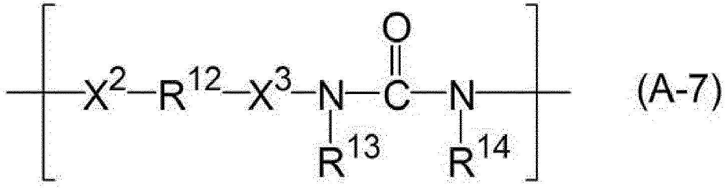 worin in der Formel A-7 R¹² eine Einfachbindung oder eine divalente Verknüpfungsgruppe darstellt; jedes von R¹³ und R¹⁴ unabhängig ein Wasserstoffatom oder eine monovalente organische Gruppe darstellt; und jedes von X² und X³ unabhängig eine durch irgendeine der Formeln A-2 bis A-6 dargestellte Verknüpfungsgruppe darstellt.

5. Flachdruckplattenvorläufer vom Positivtyp gemäß Anspruch 4, worin:
R¹² eine Einfachbindung, eine Alkylengruppe mit 6 oder weniger Kohlenstoffatomen oder eine Sulfonylgruppe darstellt; und
jedes von R¹³ und R¹⁴ unabhängig eine Alkylgruppe oder eine Arylgruppe darstellt.

6. Flachdruckplattenvorläufer vom Positivtyp gemäß Anspruch 4 oder 5,
worin die durch die Formel A-7 dargestellte Verknüpfungsgruppe eine durch die Formel A-8 dargestellte Verknüpfungsgruppe ist: 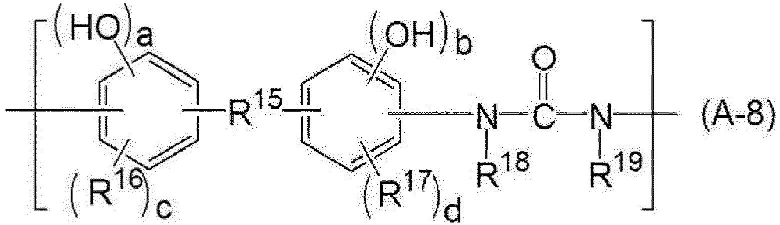 worin in der Formel A-8 R¹⁵ eine Einfachbindung oder eine divalente Verknüpfungsgruppe darstellt; jedes von R¹⁶ und R¹⁷ unabhängig ein Halogenatom oder eine monovalente organische Gruppe darstellt; jedes von R¹⁸ und R¹⁹ unabhängig ein Wasserstoffatom oder eine monovalente organische Gruppe darstellt; jedes von a, b, c und d unabhängig eine ganze Zahl von 0 bis 4 darstellt; a + b 1 bis 8 ist; und c + d 0 bis 8 - (a + b)ist.

7. Flachdruckplattenvorläufer vom Positivtyp gemäß Anspruch 6, worin:
R¹⁵ eine Einfachbindung, eine Alkylengruppe mit 6 oder weniger Kohlenstoffatomen oder eine Sulfonylgruppe darstellt; und
jedes von R¹⁶ und R¹⁷ unabhängig ein Halogenatom, eine Alkylgruppe oder eine Arylgruppe darstellt; und
jedes von R¹⁸ und R¹⁹ unabhängig eine Alkylgruppe oder eine Arylgruppe darstellt.

8. Flachdruckplattenvorläufer vom Positivtyp gemäß irgendeinem der Ansprüche 1 bis 7, umfassend eine Aufzeichnungsschicht, die eine untere Schicht und eine obere Schicht in dieser Reihenfolge auf dem Träger umfasst,
worin eine von der unteren Schicht oder der oberen Schicht die Bildaufzeichnungsschicht ist.

9. Flachdruckplattenvorläufer vom Positivtyp gemäß irgendeinem der Ansprüche 1 bis 8, ferner umfassend eine Unterzugsschicht zwischen dem Träger und der Bildaufzeichnungsschicht.

10. Verfahren zur Herstellung einer Flachdruckplatte, umfassend:
Unterziehen des Flachdruckplattenvorläufers vom Positivtyp gemäß irgendeinem der Ansprüche 1 bis 9 unter eine bildweise Belichtung; und
Unterziehen des belichteten Flachdruckplattenvorläufers vom Positivtyp unter eine Entwicklung unter Verwendung einer wässrigen Alkalilösung mit einem pH-Wert von 8,5 bis 13,5.

## Revendications

1. Précurseur de plaque d'impression planographique de type positif, comprenant :
un support ; et
une couche d'enregistrement d'image sur le support,
la couche d'enregistrement d'image comprenant : un composé polymère 1 présentant un groupe de liaison représenté par la formule A-1 suivante dans une chaîne principale de celui-ci ; un composé polymère 2-1 comprenant au moins l'un sélectionné dans le groupe consistant en un motif constitutif représenté par la formule S-1 suivante et un motif constitutif représenté par la formule S-2 suivante, ou un composé polymère 2-2 comprenant un motif constitutif représenté par la formule EV-1 suivante et un motif constitutif représenté par la formule EV-2 suivante ; et un agent absorbant les infrarouges, 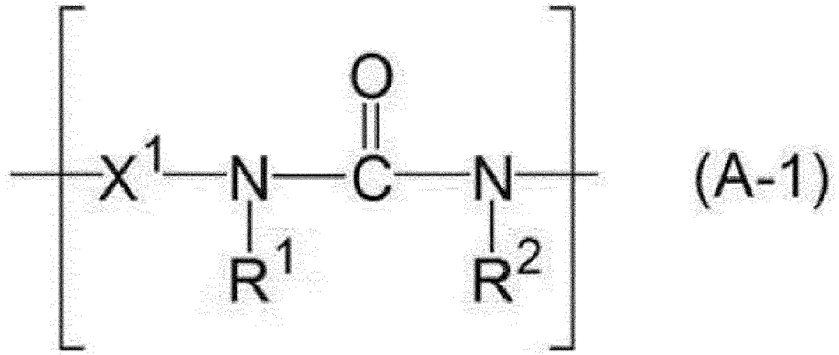
dans lequel, dans la formule A-1, chacun de R¹ et R² représente indépendamment un atome d'hydrogène ou un groupe organique monovalent ; et X¹ représente un groupe de liaison représenté par l'une quelconque des formules A-2 à A-6 suivantes : 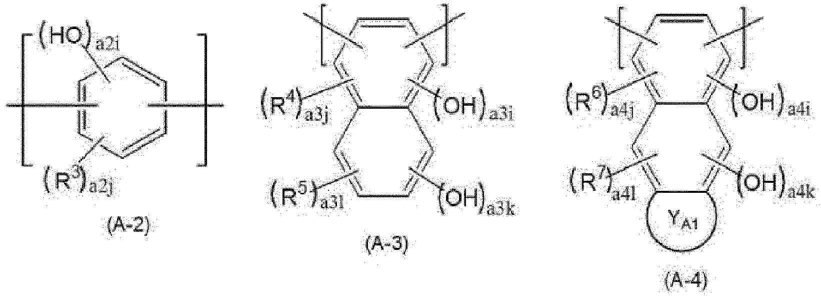 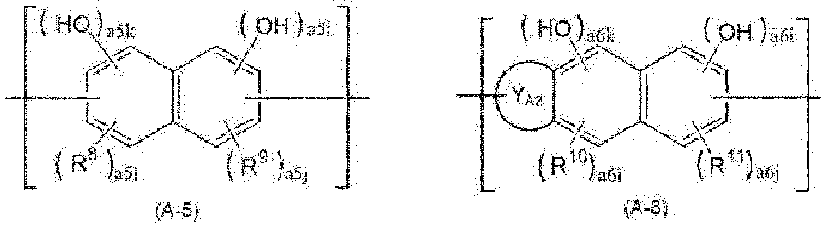
dans lesquelles, dans les formules A-2 à A-6, R³ représente un atome d'halogène ou un groupe organique monovalent ; a2i représente un entier de 1 à 4 ; a2j représente un nombre entier de 0 à 3 ; a2i + a2j est 1 à 4 ; chacun de R⁴ et R⁵ représente indépendamment un atome d'halogène ou un groupe organique monovalent ; chacun de a3i et a3j représente indépendamment un nombre entier de 0 à 2 ; chacun de a3k et a3l représente indépendamment un nombre entier de 0 à 4 ; a3i + a3k est 1 à 6 ; a3j + a3l est 0 à 6 - (a3i + a3k) ; chacun de R⁶ et R⁷ représente indépendamment un atome d'halogène ou un groupe organique monovalent ; chacun de a4i et a4k représente indépendamment un nombre entier de 0 à 2 ; a4i + a4k est 1 à 4; chacun de a4j et a4l représente indépendamment un nombre entier de 0 à 2 ; a4j + a4l est 0 à 4 - (a4i + a4k) ; Y_{A1} représente un cycle hydrocarboné aromatique ou un cycle hydrocarboné aliphatique ; chacun de R⁸ et R⁹ représente indépendamment un atome d'halogène ou un groupe organique monovalent; chacun de a5i et a5k représente indépendamment un nombre entier de 0 à 3 ; a5i + a5k est 1 à 6 ; chacun de a5j et a5l représente indépendamment un nombre entier de 0 à 3 ; a5j + a5l est 0 à 6 - (a5i + a5k) ; chacun de R¹⁰ et R¹¹ représente indépendamment un atome d'halogène ou un groupe organique monovalent; a6k représente un nombre entier de 0 à 2 ; a6i représente un entier de 0 à 3 ; a6i + a6k est 1 à 5 ; a6l représente un nombre entier de 0 à 2 ; a6j représente un nombre entier de 0 à 3 ; a6l + a6j est 0 à 5 - (a6i + a6k) ; et Y_{A2} représente un cycle hydrocarboné aromatique ou un cycle hydrocarboné aliphatique : 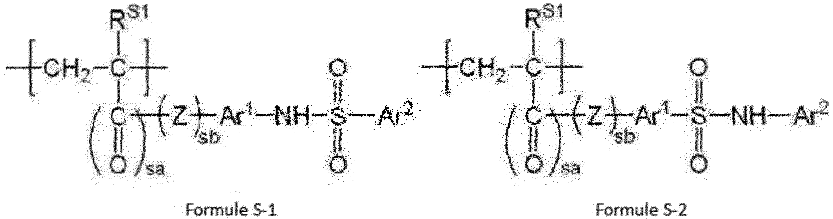
dans lesquelles, dans les formules S-1 et S-2, R^{S1} représente un atome d'hydrogène ou un groupe alkyle ; Z représente -O- ou -N(R^{S2} ), dans lequel R^{S2} représente un atome d'hydrogène, un groupe alkyle, un groupe alcényle, ou un groupe alcynyle ; chacun de Ar¹ et Ar² représente indépendamment un groupe aromatique, et au moins l'un de Ar¹ ou Ar² représente un groupe hétéroaromatique ; et chacun de sa et sb représente indépendamment 0 ou 1 ; et 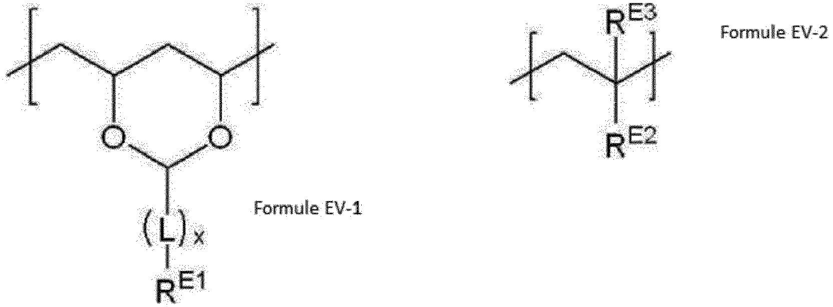
dans lesquelles, dans les formules EV-1 et EV-2, L représente un groupe de liaison divalent ; x représente 0 ou 1 ; R^{E1} représente un cycle aromatique qui contient au moins un groupe hydroxy ou un cycle hétéroaromatique qui contient au moins un groupe hydroxy ; et chacun de R^{E2} et R^{E3} représente indépendamment un atome d'hydrogène, un atome d'halogène, un groupe alkyle linéaire, ramifié ou cyclique qui peut présenter un substituant, un groupe alcényle linéaire, ramifié ou cyclique qui peut présenter un substituant, un cycle aromatique qui peut présenter un substituant, ou un cycle hétéroaromatique qui peut présenter un substituant.

2. Précurseur de plaque d'impression planographique de type positif selon la revendication 1, dans lequel chacun de R¹ et R² représente indépendamment un atome d'hydrogène, un groupe alkyle, ou un groupe aryle.

3. Précurseur de plaque d'impression planographique de type positif selon la revendication 1 ou 2, dans lequel :
R³ représente un atome d'halogène, un groupe alkyle, ou un groupe aryle ;
chacun de R⁴ et R⁵ représente indépendamment un atome d'halogène, un groupe alkyle, ou un groupe aryle ;
chacun de R⁶ et R⁷ représente indépendamment un atome d'halogène, un groupe alkyle, ou un groupe aryle ;
chacun de R⁸ et R⁹ représente indépendamment un atome d'halogène, un groupe alkyle, ou un groupe aryle ; et
chacun de R¹⁰ et R¹¹ représente indépendamment un atome d'halogène, un groupe alkyle, ou un groupe aryle.

4. Précurseur de plaque d'impression planographique de type positif selon l'une quelconque des revendications 1 à 3,
dans lequel le composé polymère 1 comprend un groupe de liaison représenté par la formule A-7 suivante dans une chaîne principale de celui-ci : 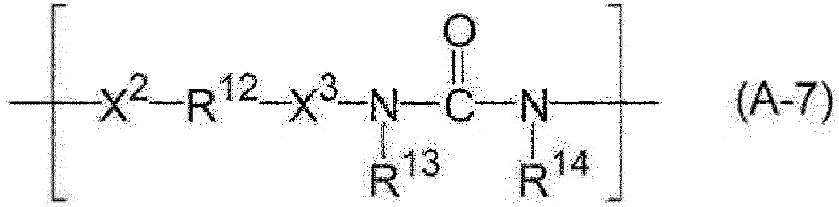 dans lequel, dans la formule A-7, R¹² représente une liaison simple ou un groupe de liaison divalent ; chacun de R¹³ et R¹⁴ représente indépendamment un atome d'hydrogène ou un groupe organique monovalent ; et chacun de X² et X³ représente indépendamment un groupe de liaison représenté par l'une quelconque des formules A-2 à A-6.

5. Précurseur de plaque d'impression planographique de type positif selon la revendication 4, dans lequel :
R¹² représente une liaison simple, un groupe alkylène présentant 6 atomes de carbone ou moins, ou un groupe sulfonyle ; et
chacun de R¹³ et R¹⁴ représente indépendamment un groupe alkyle ou un groupe aryle.

6. Précurseur de plaque d'impression planographique de type positif selon la revendication 4 ou 5,
dans lequel le groupe de liaison représenté par la formule A-7 est un groupe de liaison représenté par la formule A-8 suivante : 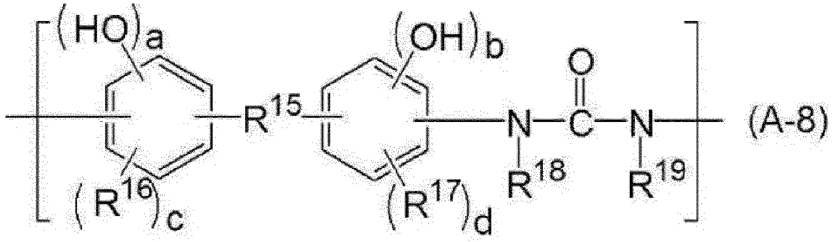 dans lequel, dans la formule A-8, R¹⁵ représente une liaison simple ou un groupe de liaison divalent ; chacun de R¹⁶ et R¹⁷ représente indépendamment un atome d'halogène ou un groupe organique monovalent ; chacun de R¹⁸ et R¹⁹ représente indépendamment un atome d'hydrogène ou un groupe organique monovalent; chacun de a, b, c et d représente indépendamment un nombre entier de 0 à 4 ; a + b est 1 à 8 ; et c + d est 0 à 8 - (a + b).

7. Précurseur de plaque d'impression planographique de type positif selon la revendication 6, dans lequel :
R¹⁵ représente une liaison simple, un groupe alkylène présentant 6 atomes de carbone ou moins, ou un groupe sulfonyle ; et
chacun de R¹⁶ et R¹⁷ représente indépendamment un atome d'halogène, un groupe alkyle, ou un groupe aryle ; et
chacun de R¹⁸ et R¹⁹ représente indépendamment un groupe alkyle ou un groupe aryle.

8. Précurseur de plaque d'impression planographique de type positif selon l'une quelconque des revendications 1 à 7, comprenant une couche d'enregistrement présentant une couche inférieure et une couche supérieure dans cet ordre sur le support,
dans lequel au moins l'une parmi la couche inférieure ou la couche supérieure est la couche d'enregistrement d'image.

9. Précurseur de plaque d'impression planographique de type positif selon l'une quelconque des revendications 1 à 8, comprenant en outre une sous-couche entre le support et la couche d'enregistrement d'image.

10. Procédé de préparation d'une plaque d'impression planographique, comprenant :
la soumission du précurseur de plaque d'impression planographique de type positif selon l'une quelconque des revendications 1 à 9 à une exposition lumineuse en forme d'image ; et
la soumission du précurseur de plaque d'impression planographique de type positif exposé à un développement en utilisant une solution aqueuse alcaline présentant un pH de 8,5 à 13,5.
